# EUROPEAN PATENT APPLICATION

(11) **EP 4 685 612 A1**
(43) Date of publication of application: **28.01.2026**
(21) Application number: 25174873.7
(22) Date of filing: 07.05.2025
(51) Int. Cl.: G06F 1/20, H05K 7/20

(54) **DYNAMIC TEMPERATURE RANGE RESET PREVENTION FOR ADVANCED EDGE SYSTEMS**

(30) Priority: 24.07.2024 US 202418783322
(71) Applicant: Intel Corporation, Santa Clara, CA 95054 (US)
(72) Inventor: GUIM BERNAT, Francesc, 08036 Barcelona (ES); KUMAR, Karthik, Chandler, 85249 (US); LEE, Eng Kwong, 11950 Bayan Lepas (MY); LIM, Chew Ching, 11950 Bayan Lepas, Penang (MY); CARRANZA, Marcos, Portland, 97229 (US)
(74) Representative: Maiwald GmbH

(57) **Abstract**

Dynamic temperature range management techniques are described. A method comprises detecting a temperature of a semiconductor die meets a first threshold value of a dynamic temperature range for the semiconductor die, generating a first control directive for a liquid cooling system to start delivery of a cooling fluid to a liquid cooling component of the semiconductor die to reduce the temperature of the semiconductor die, detecting the temperature of the semiconductor die meets a second threshold value of the dynamic temperature range for the semiconductor die, the second threshold value lower than the first threshold value of the dynamic temperature range, and generating a second control directive to stop delivery of the cooling fluid to the liquid cooling component of the semiconductor die. Other embodiments are described and claimed.

## Description

### BACKGROUND

The increased growth and sophistication of artificial intelligence (AI) have driven design of larger and more powerful processors to manage the demands of large-scale language training programs required by AI developers. For example, semiconductor chips may contain billions of transistors (e.g., fin field-effect (FinFET) transistors) with decreasing die sizes that can execute tera floating point operations per second (TFLOP) of performance. With the increased demand for AI and the vast amounts of data needed to build AI services coupled with the increasing volume of data generated by other sources, such as edge computing and sixth generation (6G) cellular networks, the need for sustainable and scalable compute and storage solutions is becoming more urgent. However, an increase in data center capacity to fill this need is also resulting in an increase in energy consumption. This increase in data center energy demand is testing the limits of legacy thermal technologies. Effectively and efficiently cooling these chips presents new thermal challenges for legacy cooling technologies.

### BRIEF DESCRIPTION OF THE SEVERAL VIEWS OF THE DRAWINGS

To easily identify the discussion of any particular element or act, the most significant digit or digits in a reference number refer to the figure number in which that element is first introduced.
FIG. 1 illustrates a perspective view of a semiconductor package in accordance with one embodiment.
FIG. 2 illustrates an operating environment in accordance with one embodiment.
FIG. 3 illustrates an apparatus in accordance with one embodiment.
FIG. 4 illustrates a semiconductor device in accordance with one embodiment.
FIG. 5 illustrates a semiconductor device in accordance with one embodiment.
FIG. 6 illustrates an edge computing system in accordance with one embodiment.
FIG. 7 illustrates an edge computing system in accordance with one embodiment.
FIG. 8 illustrates an edge computing system in accordance with one embodiment.
FIG. 9 illustrates a system in accordance with one embodiment.
FIG. 10 illustrates a logic flow in accordance with one embodiment.
FIG. 11 illustrates a computer-readable storage medium in accordance with one embodiment.
FIG. 12 illustrates a computing architecture in accordance with one embodiment.
FIG. 13 illustrates a communications architecture in accordance with one embodiment.

### DETAILED DESCRIPTION

Embodiments generally relate to liquid cooling techniques for thermal management of semiconductor devices. Some embodiments particularly relate to liquid cooling techniques to automatically increase cooling of a semiconductor device to allow the semiconductor device to operate in a wider temperature range relative to defined specifications for the semiconductor device set by an original equipment manufacturer (OEM), an original device manufacturer (ODM), or device end-user. This allows the semiconductor device to continuously operate, without experiencing interruptions or device resets, when implement in operating environments where an operating temperature normally fluctuates outside of the defined specifications, such as embedded devices like Internet of Things (IOT) devices used for industrial, transportation, or medical applications.

Data centers are complex systems in which multiple technologies and pieces of hardware interact to maintain safe and continuous operation of servers. With so many systems requiring power, the electrical energy used generates thermal energy. As the center operates, this heat builds and, unless removed, can cause equipment failures, system shutdowns, and physical damage to components. Much of this increased heat can be attributed to different processing units, collectively referred to as an "XPU," where X stands for different letters depending on the context or specific function of the processing unit, which represents a shift towards more specialized, task-specific processors. Examples of an XPU include a central processing unit (CPU), graphics processing unit (GPU), data processing unit (DPU), vision processing unit (VPU), neural processing unit (NPU), infrastructure processing unit (IPU), tensor processing unit (TPU), and other processing units. Each new generation of XPU processor seems to offer greater speed, functionality, and storage, and chips are being asked to carry more of the load.

An increasingly urgent challenge is to find a new approach to cooling data centers that reaches beyond legacy thermal technologies, that is both energy-efficient and scalable, with the ultimate goal of enabling greater compute and data storage in an energy-efficient context. Effective operation of any processor depends on temperatures remaining within designated thresholds. The more power an XPU uses, the hotter it becomes. When a component approaches its maximum temperature, a device may attempt to cool the processor by adjusting operational parameters, such as lowering its clock speed, voltage, frequency, or activating thermal throttling. While effective in the short term, repeated throttling can have negative effects, such as shortening the life of the component.

A thermal management approach to potentially cool data centers is referred to as liquid cooling. Examples of liquid cooling techniques include direct liquid cooling, also known as direct-to-chip (DTC) cooling, and liquid immersion cooling. DTC cooling, manages heat through the direct application of a coolant liquid onto the heat-generating components, such as processors and memory units. Unlike traditional air cooling that uses fans to circulate air around these components, direct liquid cooling involves circulating a coolant through a closed loop that absorbs heat directly from the components. This process significantly enhances cooling efficiency because liquids generally have higher heat capacity and conductivity than air. In direct liquid cooling systems, the coolant is pumped through cold plates that are in direct or indirect contact with the components. The heat from the components is transferred to the coolant. It is then circulated away and cooled through a heat exchanger. This method allows for more effective heat dissipation, enabling higher performance, increased component density, and potentially quieter operation due to the reduced need for fans. Direct liquid cooling is particularly beneficial in high-performance computing environments, like data centers and servers, as well as in high-end gaming personal computers and workstations, where the heat generated can exceed the capabilities of traditional air cooling methods.

In liquid immersion cooling systems, an immersion tank is filled with a dielectric fluid that partially or fully covers electronic components. The fluid dissipates heat generated by the electronic components. In open bath systems, an immersion tank is covered or uncovered and operates at atmospheric pressure. In closed bath systems, an immersion tank seals off the immersion fluid from the environment. The electronic components are fully submerged in a thermally conductive, electrically non-conductive liquid within a sealed enclosure. The closed bath immersion tank prevents the cooling liquid from coming into contact with the external environment. This enclosure helps in maintaining the integrity and cleanliness of the liquid, preventing contamination and evaporation.

Conventional liquid cooling systems suffer from various disadvantages. For example, current immersion cooling approaches typically require submerging servers in large fluid-filled tanks. While this approach works in many scenarios, such as edge installations, it can be cumbersome to implement in a traditional rack-oriented data center. Further, conventional liquid cooling systems face serviceability and replacement challenges due to the potential loss of immersion fluid while removing or inserting a rack-level computing system (e.g., blade, server, sled, etc.). As computing services grow across several thousands of locations in remote areas, there is a need to reduce costs by reducing onsite maintenance and serviceability as much as possible. Liquid cooling solutions, and immersion cooling in particular, can be used to mitigate high power consumption and thermal dissipation, while at the same time, offering the potential to drive down maintenance costs. One of the biggest contributors to maintenance costs is serviceability. When a processor or component goes bad, or when an immersion cooling solution leaks, maintenance and serviceability becomes significantly harder with immersion cooling solutions. As a result, the entire platform needs to be shipped back for maintenance or replacement. This is not a scalable approach and remains a large barrier to widespread adoption of the technology. Another problem is lack of standards in this space. Given there are currently no standards, a proprietary solution from one vendor cannot be swapped out for something from a different vendor. This makes manageability and maintenance very challenging, and vendor specific, thereby limiting the ability of these technologies to scale. Current solutions simply ship and replace the cooling solution. There is no drop in replacement capability at the edge today. Furthermore, current liquid cooling solutions are actively running constantly, particular in edge systems. This reduces a service life for the liquid cooling solutions while increasing the maintenance and serviceability issues associated with such systems.

Embodiments address these and other challenges using novel liquid cooling techniques and architectures designed to momentarily or temporarily adjust cooling of a semiconductor device when the semiconductor approaches thermal limits. This allows the semiconductor device to effectively operate in a wider temperature range relative to defined specifications for the semiconductor device set by an OEM, ODM, or a device operator. Embodiments introduce a transient liquid cooling system comprising, in part, a temperature sensor and a miniature liquid cooling reservoir that operates when a silicon junction temperature (Tj) of a semiconductor is approaching a dynamic temperature range (DTR) limit of a semiconductor device, such as an XPU, for example. The DTR defines a range of temperatures within which a silicon is able to execute full performance in a single power cycle, such as between a startup temperature and a final operating temperature. Liquid cooling logic of the transient liquid cooling system takes Tj as an input to initiate miniature liquid cooling to instantaneously boost a cooling capability of a liquid cooling component of the semiconductor device. Non-limiting examples of liquid cooling components include a heat sink, a cold plate, or other thermal management parts. By doing so, the Tj is momentarily lowered and the semiconductor device can operate at a wider temperature range to prevent reset and/or reboot sequences of the semiconductor device. By temporarily adjusting an amount of cooling applied to a semiconductor device on an on-demand or as-needed basis, the transient liquid cooling system is more efficient than conventional liquid cooling systems that are constantly applying liquid cooling to the semiconductor device, even when the semiconductor device is operating within DTR limits.

Additionally, or alternatively, the transient liquid cooling system implements an algorithm for predicting a likelihood of getting closer to DTR limit based on historical information. For example, a machine learning (ML) algorithm trains a machine learning (ML) model in a cloud computing center or an edge system using a training dataset comprising historical information of a particular platform that gets collected over time and that is correlated with the DTR zone for the semiconductor device. The ML algorithm extracts features from the historical information, such as ambient, load, time of day, and other relevant features. Non-limiting examples of a ML model include an artificial neural network (ANN) such as a recurrent neural network (RNN), a long short-term memory LSTM neural network, a convolutional neural network (CNN), a deep learning neural network (DNN), and so forth. Hence, in situations with high probability that a DTR limit or a DTR zone will be reached, the transient liquid cooling system activates liquid cooling to perform temporary cooling of the semiconductor device. When the temperature sensor indicates that Tj is within a DTR limit or a DTR zone by a defined margin, the transient liquid cooling system deactivates liquid cooling to reduce or cease cooling of the semiconductor device.

In one embodiment, for example, an apparatus for the transient liquid cooling system comprises circuitry and memory that stores instructions that, upon execution by the circuitry, causes the circuitry to detect a temperature of a semiconductor die reaching a defined first threshold value (e.g., a defined temperature) of a dynamic temperature range. For example, the temperature may comprise a silicon junction temperature measured by a thermal sensor. Upon reaching this threshold, the circuitry issues a first control directive aimed at initiating the delivery of a cooling fluid to a liquid cooling component of the semiconductor die, thereby momentarily reducing the temperature for the semiconductor die. When the temperature drops to a second threshold value (e.g., a defined temperature) within the same dynamic temperature range, the circuitry generates a second control directive to cease delivery of the cooling fluid. Typically, the second threshold value is lower than the first threshold value. Additionally, the circuitry may generate a third control directive to drain the cooling fluid from the liquid cooling component, optimizing the thermal management process. The first and second threshold values are defined to maintain a temperature of the semiconductor die within a predefined safe operational temperature range, with the first threshold indicative of a higher temperature necessitating cooling intervention and the second threshold representing an acceptable lower temperature permitting the cessation of cooling efforts. These threshold values, delineating the safe and operational temperature ranges, can be defined or adjusted through the use of a machine learning model, highlighting an adaptive and intelligent approach to managing a thermal state of the semiconductor die. This dynamic approach to thermal management ensures optimal performance and longevity of semiconductor components.

Embodiments provide several technical advantages relative to conventional solutions. For example, the transient liquid cooling system prevents service interruption of semiconductor devices, such as XPU, caused by a reset triggered when out of range of a DTR limit. The sudden boost in cooling solution capability enables wider operating temperature range while at the same time remaining compliant to DTR requirements, thereby providing a better user experience. The transient liquid cooling system also provides flexibility in Tj set point to onset of its operation. ODMs and/or OEMs can customize the transient liquid cooling system based on end user requirements in actual product deployment. In addition, it serves as product differentiation feature to device operators. The transient liquid cooling system reduces complexity and is therefore less costly to implement than conventional full-feature liquid cooling. Most IOT devices, for example, do not typically require conventional full time liquid cooling during normal operations. Therefore, the transient liquid cooling system triggers liquid cooling along with other elements on an as-needed or on-demand basis to prevent processor reset or reboot.

The technologies described herein may be implemented in one or more electronic devices. Non-limiting examples of electronic devices that may utilize the technologies described herein include any kind of mobile device and/or stationary device, such as microelectromechanical systems (MEMS) based electrical systems, gyroscopes, advanced driving assistance systems (ADAS), fifth generation (5G) and sixth generation (6G) communication systems, cameras, cell phones, computer terminals, desktop computers, electronic readers, facsimile machines, kiosks, netbook computers, notebook computers, internet devices, payment terminals, personal digital assistants, media players and/or recorders, servers (e.g., blade server, rack mount server, combinations thereof, etc.), set-top boxes, smart phones, tablet personal computers, ultra-mobile personal computers, wired telephones, combinations thereof, and the like. Such devices may be portable or stationary. In some embodiments, the technologies described herein may be employed in a desktop computer, laptop computer, smart phone, tablet computer, netbook computer, notebook computer, personal digital assistant, server, combinations thereof, and the like. More generally, the technologies described herein may be employed in any of a variety of electronic devices, including semiconductor packages having cold plates and manifolds over package substrates that have a plurality of semiconductor dies, where each semiconductor die is cooled with one or more liquid cooling paths.

As used herein the terms "top," "bottom," "upper," "lower," "lowermost," and "uppermost" when used in relationship to one or more elements are intended to convey a relative rather than absolute physical configuration. Thus, an element described as an "uppermost element" or a "top element" in a device may instead form the "lowermost element" or "bottom element" in the device when the device is inverted. Similarly, an element described as the "lowermost element" or "bottom element" in the device may instead form the "uppermost element" or "top element" in the device when the device is inverted.

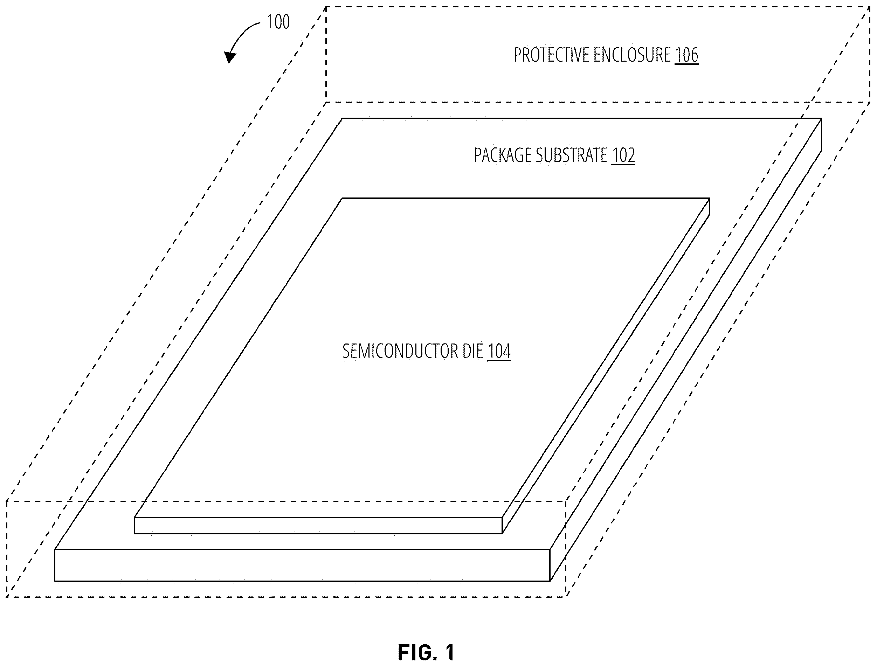

FIG. 1 is an example of a semiconductor package 100 suitable for use with a transient liquid cooling system as described herein. As depicted in FIG. 1, the semiconductor package 100 comprises core packaging components such as a package substrate 102 and one or more semiconductor dies 104 mounted on the package substrate 102, both of which are encapsulated by a protective enclosure 106. It is worthy to note that a semiconductor package 100 may include additional packaging components not shown in FIG. 1. For example, a semiconductor package 100 typically includes layers of conductive traces, electrical connectors, and support structures for the semiconductor die 104. These components are not shown for purposes of clarity and not limitation. Embodiments are not limited to the example shown in FIG. 1.

The semiconductor package 100 comprises a protective enclosure 106 for one or more semiconductor dies 104 mounted on a package substrate 102. The protective enclosure 106 provides electrical connections to external circuits and mechanical protection. It facilitates the integration of the semiconductor die 104 into larger electronic devices and circuit boards. The semiconductor package 100 also plays a role in heat dissipation, helping to remove the heat generated by the semiconductor die 104 and maintain optimal operating conditions. Examples of different types of semiconductor packages 100 include a Dual Inline Package (DIP), a Ball Grid Array (BGA), and a Quad Flat Package (QFP). Each semiconductor package 100 is designed to meet different requirements in terms of size, performance, and application. The choice of a semiconductor package 100 directly affects reliability, performance, cost, and size of an electronic device.

The package substrate 102 of the semiconductor package 100 acts as an intermediary platform between the semiconductor die 104 and external circuitry. An examples of package substrate 102 is a printed circuit board (PCB). It serves as a foundation on which the semiconductor die 104 is mounted and provides a pathway for electrical signals from the semiconductor die 104 to reach the external connections of the semiconductor package 100. The package substrate 102 is engineered from materials like ceramic, organic resin, or silicon, and it features multiple layers that include conductive traces and vias to facilitate electrical connectivity. These layers are meticulously designed to manage signal integrity, power distribution, and thermal performance. The package substrate 102 not only supports mechanical integrity and enhances the electrical performance of the semiconductor client device but also plays a vital role in heat dissipation, ensuring the longevity and reliability of the semiconductor die 104 by maintaining thermal conditions within operational limits. In one embodiment, the package substrate 102 is a PCB made of an FR-4 glass epoxy base with thin copper foil laminated on both sides. In some embodiments, the PCB is a multilayer PCB, with a pre-impregnated (pre-preg) layer and copper foil used to make additional layers. For example, the multilayer PCB may include one or more dielectric layers, where each dielectric layer can be a photosensitive dielectric layer. In some embodiments, holes may be drilled in the package substrate 102. The package substrate 102 may also include conductive layers that comprise conductive (or copper) traces, pads, vias, via pads, planes, and/or holes.

The semiconductor die 104 is a relatively small, thin piece of semiconductor material, typically silicon, that has been carefully fabricated to contain an integrated circuit (IC). The IC comprises numerous electronic components such as transistors, diodes, and resistors, all intricately patterned on the semiconductor substrate through processes like photolithography, etching, and doping. These components are interconnected to perform various electronic functions, ranging from simple logic operations to complex computational tasks. The semiconductor die 104 is encased in the protective enclosure 106 to form a complete electronic device, ensuring its functionality and reliability in a wide range of applications, including computers, smartphones, and various electronic systems. In an embodiment, the semiconductor die 104 may be implemented as a microprocessor, a microelectronic device, a semiconductor chip, a chiplet, an integrated circuit (IC), a circuit, a processor, processing circuitry, circuitry, an XPU, a controller, a platform controller hub (PCH), a memory, a field-programmable gate array (FPGA), power management IC, electronic control unit (ECU) for an autonomous vehicle, or any other semiconductor device.

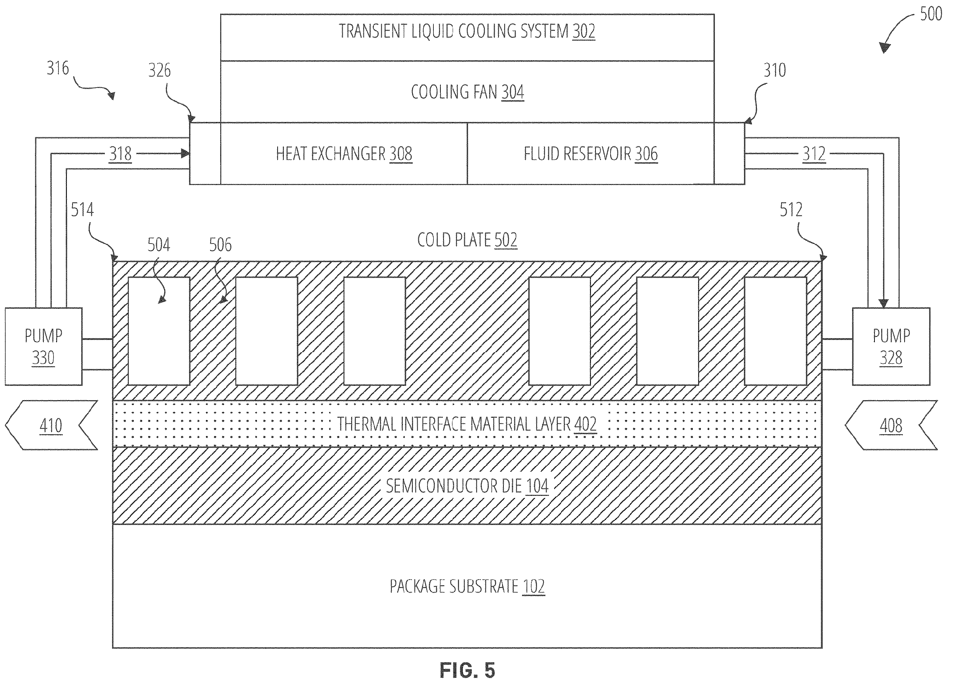

Additionally, in some embodiments as shown below in FIG. 5, thermal components such as a cold plate, a manifold, and thermal interface material (TIM) layer may be disposed over the top surface of the semiconductor die 104 and/or the package substrate 102.

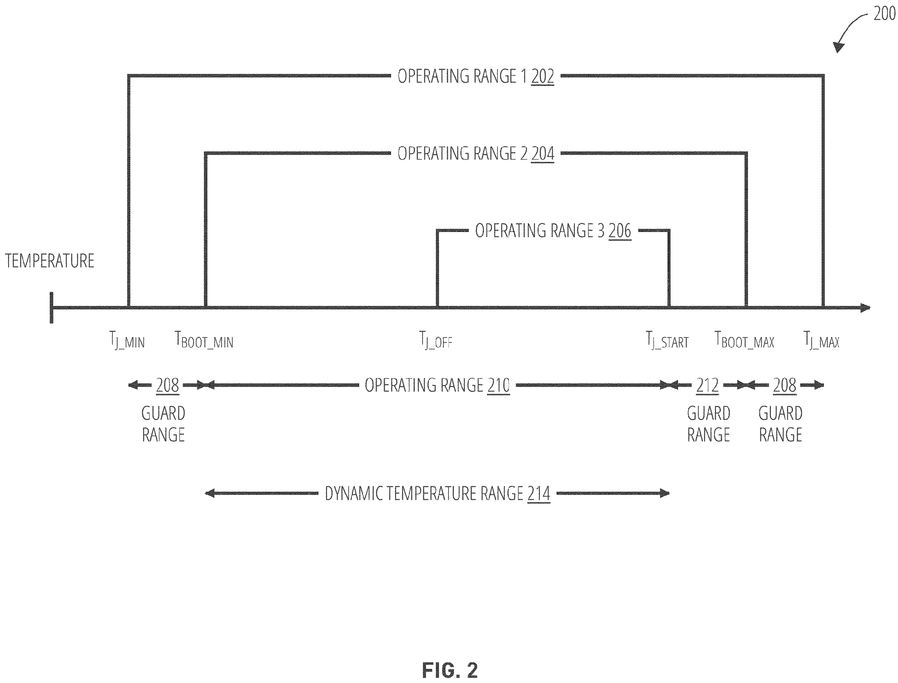

FIG. 2 illustrates an operating environment 200 for the semiconductor package 100. Specifically, the operating environment 200 is an example of a DTR 214 for the semiconductor die 104 of the semiconductor package 100.

As depicted in operating environment 200, the semiconductor die 104 is designed to operate within a set of temperature operating ranges as defined by one or more specifications. A non-limiting example of a specification is an External Design Specification (EDS). An OEM, an ODM, and/or an end-user may define different EDS, or different parameters for an EDS, of a given semiconductor die 104. A non-limiting example of an EDS defining a DTR 214 for the semiconductor die 104 is as follows: "For a single operational cycle, the processor shall execute at full data sheet performance across the full Dynamic Temperature Range (DTR) without resetting or retraining, where the processor DTR is a personal computer (PC) client stock keeping unit (SKU) is plus or minus 70°C and an embedded and industry SKU is plus or minus 90°C."

By way of example, an OEM may define an operating range 1 202 of silicon junction temperatures (Tj) between a minimum silicon temperature (Tj_min) to a maximum silicon temperature (Tj_max). An ODM or an end-user may define an operating range 2 204 of silicon junction temperatures (Tj) during a boot-up phase, such as between a minimum boot temperature (Tboot_min) and a maximum boot temperature (Tboot_max). It is worthy to note that the operating range 2 204 of a device using the semiconductor die 104 is a smaller range of Tj relative to the operating range 1 202 of the semiconductor die 104. A set of guard ranges 208 are defined between the operating range 1 202 and the operating range 2 204. The guard ranges 208 represent a guard between Tj_min and TJ_max to ensure continuous operations of the semiconductor die 104 within a given device.

The operating range 2 204 defines limits of a DTR 214 for a device implementing the semiconductor die 104 of the semiconductor package 100. The DTR 214 is a range of silicon junction temperatures (Tj) within which the semiconductor die 104 is able to execute full performance in a single power cycle, between a startup temperature and a final operating temperature. The DTR 214 is not necessarily a thermal requirement, but rather is a package reliability requirement. The DTR 214 defines an operating range 210 for the semiconductor die 104 ranging from a minimum boot temperature (Tboot_min) to a maximum boot temperature (Tboot_max). As long as the Tj of the semiconductor die 104 remains within Tboot_min and Tboot_max of the operating range 2 204, the semiconductor die 104 should operate within device specifications and not experience any thermally-related operational issues.

As with the guard ranges 208 between the operating range 1 202 and the operating range 2 204, however, the operating range 2 204 also implements a guard range as Tj approaches Tboot_max. As depicted in operating environment 200, the DTR 214 for the device is segregated into two sub-ranges, including an operating range 210 and a guard range 212. This separation limits the DTR 214 for the semiconductor die 104 to a temperature range defined by the operating range 210. Once a Tj meets the guard range 212 protecting Tboot_max, the thermal management system for the device causes the semiconductor die 104 to reset or reboot. This interrupts continuous operation of the semiconductor die 104, particularly when the semiconductor die 104 is implemented in operating environments with larger fluctuations in an ambient temperature of the operating environment. For example, a data center may implement a server blade using one or more semiconductor packages 100 comprising one or more semiconductor dies 104. When the data center is located in extreme geographical climates, such as a northern hemisphere or southern hemisphere, the ambient temperature within the data center may fluctuate above and below the operating range 210 of the DTR 214. In some cases, a data center may be located in a place that experiences seasonal variations with fluctuating temperatures, such as between summer and winter, for example. As a result, the smaller temperature range of the operating range 210 limits performance of the semiconductor die 104 depending on a location of the semiconductor die 104.

Furthermore, different semiconductor dies 104 may have different DTRs 214, some of which are narrower than others, which in turn further limits operations of the semiconductor dies 104. For example, one type of semiconductor die 104 may be a first XPU with a DTR limit of plus or minus 70°C while another type of semiconductor die 104 may be a second XPU with a DTR limit of plus or minus 90°C. The variation in DTR limits defines an allowable Tj before a reboot or reset occurs. For example, assume an ambient temperature at boot time for the first XPU is -40°C and Tj is also -40°C at boot. An allowable Tj before reset is 30°C. Assume an ambient temperature at boot time for the second XPU is -40°C and Tj is also -40°C at boot. An allowable Tj before reset is 50°C. This example illustrates that even when the allowable Tj is below a thermal requirement of Tj_max (e.g., 100°C to 110°C), there is a chance the XPU will reset itself if Tj fluctuates outside of the DTR limits.

By way of example, assume an OEM defines an EDS for semiconductor die 104 that defines an operating range 1 202 between Tj_min of -40 degrees Celsius (°C) and Tj_max of 100°C, and a DTR 214 of plus or minus 90°C. Further assume an ODM defines a device specification for a device implementing the semiconductor die 104 that defines an operating range 2 204 between Tboot_min of -25°C and Tboot_max of 70°C. When the operating temperature swings from -25°C to 70°C, the DTR 214 will be greater than 90°C. This implies the semiconductor die 104 will be reset due to the DTR limit of 90°C, thereby interrupting operations for the semiconductor die 104.

Embodiments implement a transient liquid cooling system that effectively extends the operating range 210 of the existing DTR 214 of the semiconductor die 104 to include some or all of the guard range 212, hence preventing the violation of DTR 214. The transient liquid cooling system accepts as input a set of defined thresholds to automatically trigger a temporary liquid cooling solution to the semiconductor die 104. For example, the set of defined thresholds are design parameters defined by an OEM, an ODM, an end-user, or a ML model. The design parameters may include a temperature (Tj) that starts or initiates transient liquid cooling (Tj_start) of the semiconductor die 104, where Tj_start = DTR - X°C, and X represents any positive value. The design parameters may further include a temperature (Tj) that ends or terminates the transient liquid cooling (Tj_off) of the semiconductor die 104, where Tj_off = DTR - Y°C, and Y represents any positive value. For example, assume the values X = 5 and Y = 20. When DTR = 90°C, then Tj_start = 90°C - 5°C = 85°C and Tj_off = 90°C - 20°C = 70°C. When Tj_start reaches 85°C then the transient cooling system starts liquid cooling of the semiconductor die 104. When Tj_off reaches 70°C then the transient cooling system ends liquid cooling of the semiconductor die 104. This process continuously repeats as Tj of the semiconductor die 104 cycles between Tj_start and Tj_off. Due to the time it takes for the liquid cooling of the semiconductor die 104 to lower a Tj for the semiconductor die 104, the Tj of the semiconductor die 104 may temporarily exceed a boundary for the guard range 212. As such, the transient liquid cooling system effectively extends the operating range 210 of the existing DTR 214 of the semiconductor die 104 that uses the operating range 210 and some or all of the guard range 212.

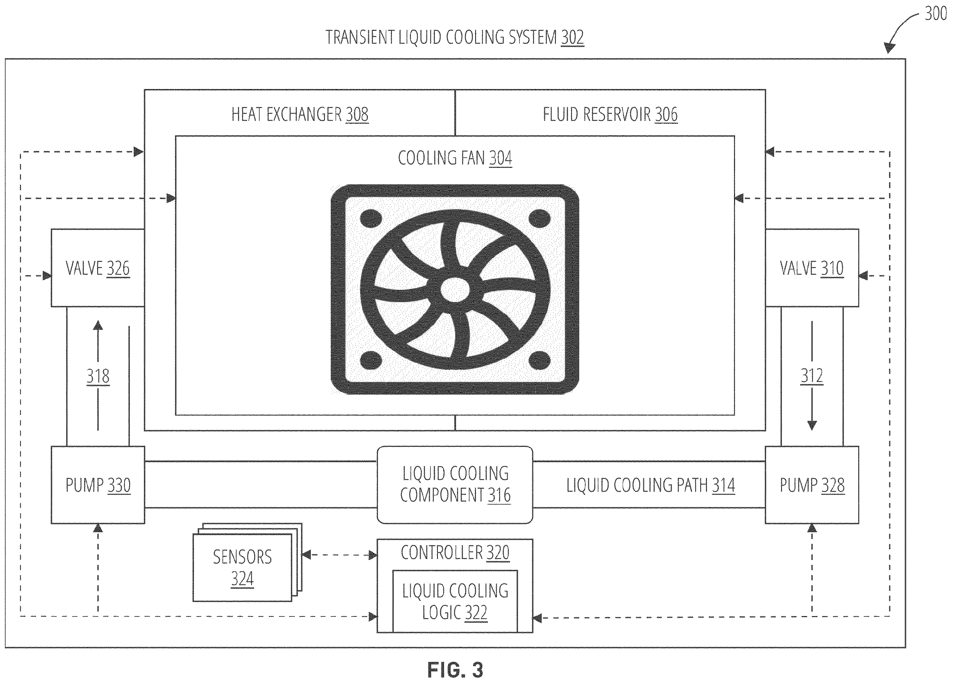

FIG. 3 illustrates a top view of an apparatus 300. The apparatus 300 is an example architecture for a transient liquid cooling system as described herein.

As depicted in FIG. 3, the apparatus 300 comprises a transient liquid cooling system 302. The transient liquid cooling system 302 further comprises a cooling fan 304, a fluid reservoir 306, a heat exchanger 308, a cooling fluid 312 flowing along a liquid cooling path 314, a controller 320 executing liquid cooling logic 322, a set of sensors 324, a valve 310 to the fluid reservoir 306, a valve 326 to the heat exchanger 308, a pump 328 to pump cooling fluid 312 from the fluid reservoir 306 to a liquid cooling component 316 via the valve 310, and a pump 330 to pump heated cooling fluid 318 from the liquid cooling component 316 to the heat exchanger 308 via the valve 326. It may be appreciated that the example architecture for the apparatus 300 may include more or less components as needed for a given implementation. Embodiments are not limited to this example.

The transient liquid cooling system 302 may include one or more cooling fans 304. In the transient liquid cooling system 302, a cooling fan 304 is a component that aids in removing heat from the heated cooling fluid 318 after the cooling fluid 312 has absorbed heat from the liquid cooling component 316 cooling a semiconductor die 104, such as a computer CPU, GPU, XPU, or other electronic components. While a primary mechanism of heat transfer in the transient liquid cooling system 302 occurs through the circulation of the cooling fluid 312 that absorbs heat from the electronic components and carries it away, the cooling fan 304 plays a role in the heat dissipation process at the heat exchanger 308, such as a radiator, for example. The radiator is a part of the transient liquid cooling system 302 where the heated cooling fluid 318 is directed through thin tubes of a cold plate or fins of a heat sink. As the heated cooling fluid 318 passes through the radiator, the heat it carries is dissipated into the surrounding air. The cooling fan 304 blows air across radiator fins, significantly enhancing the rate at which heat is removed from the heated cooling fluid 318. This process decreases a temperature for the heated cooling fluid 318 before it is recirculated back into the fluid reservoir 306 to absorb more heat from the components. Higher airflow can improve cooling performance but may increase noise levels. Consequently, transient liquid cooling system 302 attempts to balance cooling efficiency and noise reduction in the design and selection of cooling fans 304 for transient liquid cooling system 302.

The transient liquid cooling system 302 may include one or more fluid reservoirs 306. The fluid reservoir 306 is a component that holds the cooling fluid 312 or coolant. The primary purpose of the fluid reservoir 306 is to maintain an adequate volume of cooling fluid 312 within the transient liquid cooling system 302, ensuring that there is always enough cooling fluid 312 to circulate and efficiently transfer heat away from the components being cooled, such as the semiconductor die 104. The fluid reservoir 306 acts as a storage tank for the cooling fluid 312, providing a buffer of cooling fluid 312 that can be drawn into the cooling loop as needed. This is particularly important during system startup or when any part of the system needs additional coolant due to evaporation or leakage. The fluid reservoir 306 also provides a convenient point for adding or replacing coolant in the system. It allows for easy access to the fluid for maintenance purposes, such as flushing the system or replenishing coolant levels. The fluid reservoir 306 helps in removing air bubbles from the cooling fluid 312. Air bubbles can significantly reduce the efficiency of heat transfer and can cause noise in the system. The design of the fluid reservoir 306 allows air bubbles to rise out of the circulating cooling fluid 312 and collect at the top, away from the main flow, where they can be vented outside the system. Having a fluid reservoir 306 can also assist in temperature stabilization. The volume of cooling fluid 312 in the fluid reservoir 306 provides a thermal buffer that can absorb and dissipate heat, helping to moderate temperature fluctuations within the system. It can also serve to relieve pressure within the cooling system. As the cooling fluid 312 heats up and expands, the fluid reservoir 306 accommodates the increased volume, preventing excessive pressure build-up that could lead to leaks or damage to system components. The fluid reservoir 306 can come in various sizes and designs, ranging from simple closed tanks to sophisticated pressurized containers, depending on system requirements and the specific applications.

The fluid reservoir 306 holds or stores cooling fluid 312. A cooling fluid 508 may transfer heat from the semiconductor die 104 to the liquid cooling component 316 which dissipates heat from the heated liquid into the ambient, or another separate liquid cooling component or system. Examples of cooling fluids 508 include engineered fluids such as 3M^{™} Novec^{™} and Fluorinert^{™}, synthetic oils, and specially formulated dielectric fluids. These fluids have high thermal conductivity and are electrically insulating. Two parameters of cooling fluid 508 to consider when choosing a cooling fluid 508 for use in a particular cooling implementation are its flammability and global warming potential (GWP) number, with a lower GWP number indicating that a material contributes less to global warming. Some synthetic single-phase cooling liquids (e.g., Novec fluids) have good thermal performance but also have a high GWPs. As there are worldwide efforts to phase out the use of greenhouse gases, such as hydrofluorocarbons, there is interest in using non-GWP or low-GWP materials (e.g., materials having a GWP<1) where possible. The liquid cooling technologies disclosed herein can provide for the liquid cooling of electronic devices and systems comprising high-performance IC components using non-flammable and/or non-GWP or low-GWP fluids. The use of such technologies can aid large cloud service providers (CSPs), high-performance computing (HPC) system vendors, and other entities that may begin to increasingly rely on liquid cooling in data centers to meet defined environmental sustainability (e.g., carbon-neutral, carbon-negative) goals.

The transient liquid cooling system 302 may include one or more heat exchangers 308. A heat exchanger 308 is a component designed to dissipate heat away from the transient liquid cooling system 302 to maintain optimal operating temperatures. The operation involves the heated cooling fluid 318 flowing into one side of the heat exchanger 308 from the pump 330, while the cooling fluid 312 flows out the other side to the fluid reservoir 306. The design of the heat exchanger 308 facilitates a large surface area for the heat to transfer across the barrier separating the two fluids. The thermal energy from the hot side is absorbed by the cooler side, effectively removing heat from the system. Non-limiting examples for the heat exchanger 308 includes: (1) a radiator that allows the heated cooling fluid 318 to flow through fins or tubes where it is cooled by air flowing through the radiator aided by the cooling fan 304; (2) a plate heat exchanger comprising multiple, thin, slightly separated plates that have large surface areas and fluid flow passages for heat transfer; (3) a shell and tube heat exchanger using a series of tubes, where one set carries the heated cooling fluid 318, while the other set carries a cooling medium; (4) a micro-channel heat exchanger that utilizes many small channels through which the heated cooling fluid 318 flows. The choice of heat exchanger 308 in the transient liquid cooling system 302 depends on various factors including the required heat transfer efficiency, space constraints, the type of fluids involved, and the temperature range within which the system operates.

The transient liquid cooling system 302 includes a set of valves, such as valve 310 and valve 326. A valve is a mechanical device that controls the flow of the cooling fluid 312 and the heated cooling fluid 318 through the transient liquid cooling system 302. It can adjust the flow rate, direct the flow path, or completely stop the flow, depending on the operational requirements of the system. Non-limiting examples of valves include ball valves, gate valves, globe valves, check valves, solenoid valves, needle valves, and so forth. In one embodiment, for example, the valve 310 and the valve 326 are implemented as solenoid valves, which are electrically controlled valves that can open or close the flow of liquid coolant in response to an electrical signal from the controller 320, thereby offering precise control over the transient liquid cooling system 302.

The transient liquid cooling system 302 may include one or more pumps, such as pump 328 and pump 330. A pump is a component responsible for circulating the cooling fluid 312 and the heated cooling fluid 318 throughout the transient liquid cooling system 302. It propels the cooling fluid 312 and the heated cooling fluid 318 through pipes, tubes, and other components such as the heat exchanger 308 and the liquid cooling component 316 used to cool the semiconductor die 104. The pump enables the transient liquid cooling system 302 to efficiently transfer heat away from the heat source, through cooling fluid 312, and towards the heat exchanger 308 where the heat can be dissipated into the environment, thus maintaining optimal operating temperatures. Non-limiting examples of pumps include centrifugal pumps, submersible pumps, inline pumps, diaphragm pumps, and so forth. The choice of pump in the transient liquid cooling system 302 depends on various factors, including cooling requirements, the thermal load it needs to manage, the layout and size of the cooling loop, and considerations like noise, efficiency, and maintenance.

The transient liquid cooling system 302 may include one or more controllers 320. The controllers 320 may control operations for one or more of the internal electronic components and/or the internal cooling components. For example, the controllers 320 manage the operation of the transient liquid cooling system 302 to optimize performance and ensure efficient heat dissipation. It regulates various parameters of the transient liquid cooling system 302, such as pump speed of pump 328 and/or pump 330 to control the flow rate of the coolant to balance cooling efficiency and noise levels; fan speed of a cooling fan 304 to adjust the speed of fans attached to heat exchanger 308 to control airflow and noise, based on the temperature of the coolant or the components being cooled; uses sensors 324 to monitor temperatures at critical points in the system, such as the liquid coolant, the radiator, and the components being cooled (like CPUs or GPUs); and other management operations. The controllers 320 can operate based on system management commands or control directives, preset profiles, or dynamically adjust parameters of the cooling system in real-time based on feedback from sensors 324, achieving optimal cooling efficiency, noise levels, and power consumption. Some controllers 320 offer user interfaces, allowing users to customize settings according to their preferences or specific application requirements.

The transient liquid cooling system 302 may include one or more sensors 324. The sensors 324 may monitor various properties and attributes of the transient liquid cooling system 302 to ensure efficient operation, safety, and performance monitoring. For example, the sensors 324 may include temperature sensors designed to measure the temperature of the liquid coolant and components being cooled, such as the semiconductor dies 104 and other electronic components. Common types of temperature sensors include thermocouples, thermistors, and resistance temperature detectors (RTDs). The sensors 324 may include flow sensors designed to measure a flow rate of the cooling fluid 312 in the system, ensuring it is circulating properly. Examples include turbine flow sensors, ultrasonic flow sensors, and paddlewheel sensors. The sensors 324 may include pressure sensors designed to measure the pressure of the cooling fluid 312 within the transient liquid cooling system 302. This is important for detecting leaks, blockages, or pump failures. Common types include piezoelectric pressure sensors and strain gauge pressure sensors. The sensors 324 may include level sensors designed to detect a coolant level within a reservoir or tank, ensuring the system has enough cooling fluid 312 to function properly. Types include capacitive level sensors, ultrasonic level sensors, and float level sensors. The sensors 324 may include pH sensors designed to monitor an acidity or alkalinity of the cooling fluid 312 to prevent corrosion-related damage. The sensors 324 may include conductivity sensors designed to measure the electrical conductivity of the cooling fluid 312. This can be important for detecting contamination or the concentration of additives in the cooling fluid 312. The sensors 324 may include temperature difference sensors designed to measure a temperature difference across the cooling system to assess its efficiency. Each of the sensors 324 plays a role in monitoring and controlling a liquid cooling system, contributing to its effectiveness and longevity. Embodiments are not limited to these examples.

In one embodiment, for example, the apparatus 300 comprises a transient liquid cooling system 302 that includes a fluid reservoir 306 to store a cooling fluid 312. The transient liquid cooling system 302 also includes circuitry operably coupled to the liquid cooling system, such as a controller 320. The transient liquid cooling system 302 also includes memory operably coupled to the circuitry, the memory to store instructions for liquid cooling logic 322 that when executed by the circuitry causes the circuitry to detect a temperature (Tj) of a semiconductor die 104 via one or more sensors 324. When Tj meets a first threshold value of a DTR 214 for the semiconductor die 104, the controller 320 generates a first control directive for the transient liquid cooling system 302 to start delivery of the cooling fluid 312 from the fluid reservoir 306 to a liquid cooling component 316 of the semiconductor die 104 to reduce the temperature (Tj) of the semiconductor die 104. At some time after the start of delivery of the cooling fluid 312, the controller 320 detects the temperature of the semiconductor die 104 meets a second threshold value of the DTR 214 for the semiconductor die 104, where the second threshold value is lower than the first threshold value of the DTR 214. The controller 320 generates a second control directive to stop delivery of the cooling fluid 312 from the fluid reservoir 306 to the liquid cooling component of the semiconductor die 104.

The transient liquid cooling system 302 may further include a heat exchanger 308 (e.g., a radiator) and a cooling fan 304, a first valve 310 to control delivery of the cooling fluid 312 from the fluid reservoir 306, a second valve 326 to control delivery of heated cooling fluid 318 to the heat exchanger 308, a first pump 328 to deliver the cooling fluid 312 from the fluid reservoir 306 to the liquid cooling component 316 of the semiconductor die 104 to absorb heat from the semiconductor die 104 to form heated cooling fluid 318, and a second pump 330 to deliver the heated cooling fluid 318 from the liquid cooling component 316 of the semiconductor die 104 to the heat exchanger 308 to remove heat from the heated cooling fluid 318. Once the heat exchanger 308 removes heat from the heated cooling fluid 318 to form cooling fluid 312, it returns the cooling fluid 312 to the fluid reservoir 306.

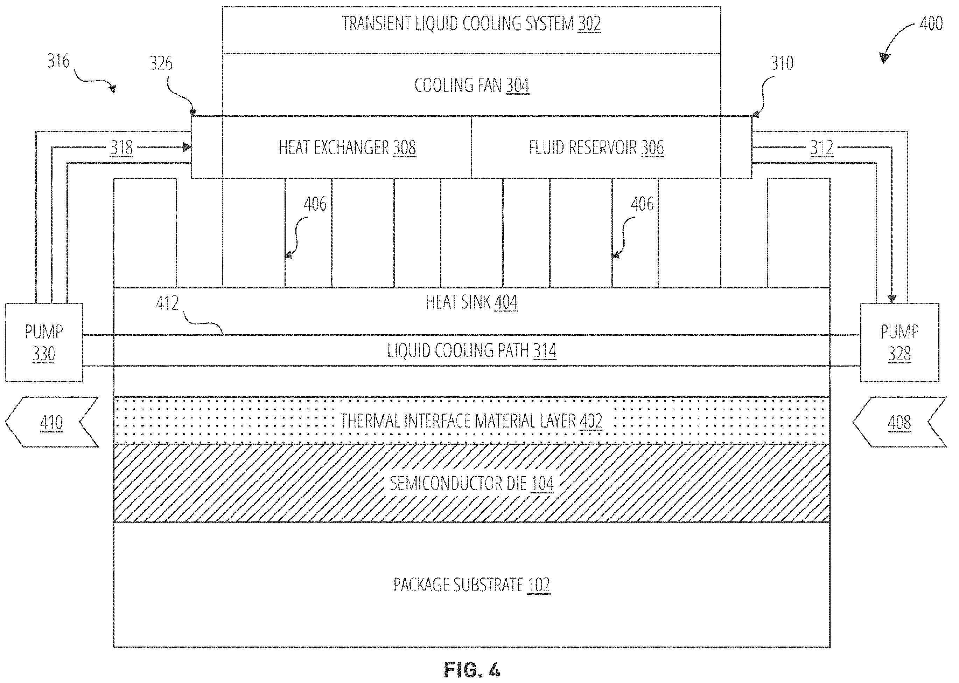

The transient liquid cooling system 302 may further include the semiconductor die 104 mounted on a package substrate 102, a thermal interface material TIM layer 402 thermally coupled to the semiconductor die 104, and the liquid cooling component 316 thermally coupled to the thermal interface material TIM layer 402. The liquid cooling component 316 may be implemented as a heat sink or a cold plate thermally coupled to the semiconductor die 104, as described with reference to FIG. 4 and FIG. 5, respectively.

When Tj approaches or meets a first threshold value of a DTR 214 for the semiconductor die 104, the liquid cooling logic 322 of the controller 320 generates a first control directive for the transient liquid cooling system 302 to start delivery of the cooling fluid 312 from the fluid reservoir 306 to the liquid cooling component 316 of the semiconductor die 104 to reduce the temperature (Tj) of the semiconductor die 104. In one embodiment, for example, the first control directive includes a set of instructions, the set of instructions comprising a first instruction to open the first valve 310 of the fluid reservoir 306, a second instruction to open the second valve 326 of the heat exchanger 308, a third instruction to the first pump 328 to deliver the cooling fluid 312 from the fluid reservoir 306 to the liquid cooling component 316 of the semiconductor die 104 to absorb heat from the semiconductor die 104 to form heated cooling fluid 318, and a fourth instruction to the second pump 330 to deliver the heated cooling fluid 318 from the liquid cooling component 316 of the semiconductor die 104 to the heat exchanger 308 to remove heat from the heated cooling fluid 318.

At some time after the start of delivery of the cooling fluid 312, the controller 320 detects the temperature of the semiconductor die 104 approaches or meets a second threshold value of the DTR 214 for the semiconductor die 104, where the second threshold value is lower than the first threshold value of the DTR 214. The liquid cooling logic 322 of the controller 320 generates a second control directive to stop delivery of the cooling fluid 312 from the fluid reservoir 306 to the liquid cooling component of the semiconductor die 104. In one embodiment, for example, the second control directive includes a set of instructions, the set of instructions comprising a first instruction to close the first valve 310 of the fluid reservoir 306, a second instruction to the first pump 328 to deliver the cooling fluid 312 to the liquid cooling component 316 of the semiconductor die 104 to absorb heat from the semiconductor die 104 to form heated cooling fluid 318, a third instruction to the second pump 330 to deliver the heated cooling fluid 318 from the liquid cooling component 316 of the semiconductor die 104 to the heat exchanger 308 to remove heat from the heated cooling fluid 318, and a fourth instruction to close the second valve 326 of the heat exchanger 308.

In one embodiment, for example, the liquid cooling logic 322 of the controller 320 may generate a third control directive to drain the cooling fluid 312 from the liquid cooling component 316 of the semiconductor die 104 back to the fluid reservoir 306. This may occur during storage or transport of a device implementing the semiconductor die 104, or to ensure that the cooling fluid 312 returns to a normal starting temperature prior to deployment in a next cooling cycle, for example.

In one embodiment, for example, one or more of the sensors 324 is a temperature sensor that measures a point on the semiconductor die 104 for a current temperature (Tj). The liquid cooling logic 322 of the controller 320 receives Tj as input. When the liquid cooling logic 322 detects that Tj is approaching or close to meeting the first threshold value, the liquid cooling logic 322 sends a control directive to the valve 310 to open so that cooling fluid 312 flows out of the fluid reservoir 306. For example, the first threshold value is Tj_start as described with reference to FIG. 2. The first threshold value is a configurable value set by the OEM, ODM, an end-user, and/or a ML model. The pump 328 pumps the cooling fluid 312 to the liquid cooling component 316, such as the heat sink 404 or the cold plate 502, which absorbs heat from the semiconductor die 104. In some cases, for example, Tj may be lowered by at least 10°C or 20°C, depending on a particular type of cooling fluid 312, design of the liquid cooling component 316, and/or design of the transient liquid cooling system 302. The pump 330 pumps the heated cooling fluid 318 out of the liquid cooling component 316 to the heat exchanger 308. The heat exchanger 308 cools the heated cooling fluid 318, added by the cooling fan 304, to form the cooling fluid 312. The heat exchanger 308 outputs the cooling fluid 312 to the fluid reservoir 306. The cycle repeats itself until Tj reaches a "safe" margin from the DTR limit and the transient liquid cooling system 302 is turned off. This is the second threshold value, such as a set point for Tj_off as described in FIG. 2.

In the transient liquid cooling system 302, the cooling fluid 312 is chosen according to the application. In general, the cooling fluid 312 is water due to its low cost. But in extreme cold environments (e.g., below sub-zero), the cooling fluid 312 is nitrogen due to its low freezing point. A temperature zone may be used to trigger the onset of the transient liquid cooling system 302, rather than absolute values for the first threshold value and second threshold value, which can be further optimized based on customer requirements or operating environments.

FIG. 4 illustrates a cross-sectional view of a semiconductor system 400 of the semiconductor package 100 with a liquid cooling component 316 of the transient liquid cooling system 302. The semiconductor system 400 depicts a cross-sectional view of the package substrate 102 and the semiconductor die 104 mounted on the package substrate 102 of the semiconductor package 100. In one embodiment, as illustrated in FIG. 4, the semiconductor system 400 does not use a protective enclosure 106. However, other embodiments may optionally use a protective enclosure 106 for the semiconductor system 400 for a given implementation. Embodiments are not limited in this context.

In addition to the package substrate 102 and the semiconductor die 104, the semiconductor system 400 comprises additional thermal management components, such as a TIM layer 402 and a liquid cooling component 316, such as a heat sink 404, for example. The thermal management components of the semiconductor package 100 implement a liquid cooling solution that enables targeted cooling of the semiconductor die 104 and/or the entire semiconductor package 100. For example, the semiconductor package 100 may implement a liquid cooling technique such as direct liquid cooling and/or liquid immersion cooling. Direct liquid cooling, also known as direct-to-chip (DTC) cooling, manages heat through the direct application of a cooling fluid 312 onto the heat-generating components, such as semiconductor dies 104. Liquid immersion cooling immerses some or all of the semiconductor die 104 within the cooling fluid 312. The cooling fluid 312 flows throughout the semiconductor package 100 along one or more liquid cooling paths, such as a liquid cooling path 314.

As described herein, a cooling fluid 312 may transfer heat from the semiconductor die 104 to the heat sink 404 which dissipates heat from the heated cooling fluid 318 into the transient liquid cooling system 302. Examples of cooling fluids 312 include engineered fluids such as 3M^{™} Novec^{™} and Fluorinert^{™}, synthetic oils, and specially formulated dielectric fluids. In one embodiment, for example, the cooling fluid 312 flowing through the liquid cooling path 314 is a non-electric-conductive, non-ionic, and non-reactive liquid (e.g., a fluorinated liquid). In another embodiment, the fluid may be water when the semiconductor die 104 is surrounded with an insulated material. In some embodiments, the cooling fluid 312 may be a fluorinated liquid type and/or a freon liquid type. Examples of a fluorinated liquid type may include without limitation FC-3283, FC-40, FC-43, FC-72, FC-75, FC-78, and FC-88. In one embodiment, for example, the freon liquid type may include freon-C-51-12, freon-E5, or freon-TF. Embodiments are not limited to these examples.

As depicted in semiconductor system 400, the heat sink 404 is disposed over a top surface of the semiconductor die 104 mounted on the package substrate 102. The heat sink 404 is designed to dissipate the heat produced by the semiconductor die 104 (e.g., an XPU, a CPU, a GPU, a memory unit, etc.) during its operation. It is typically made from a thermally conductive material, such as aluminum or copper, which helps in efficiently transferring heat away from the semiconductor die 104. The heat sink 404 has a series of heat sink fins 406 or pins that increase its surface area, making it more effective at dissipating heat into the surrounding air. The larger the surface area, the more efficiently the heat sink 404 can spread out the heat and radiate it away. Some heat sinks also incorporate heat pipes, which are hollow tubes containing a small amount of cooling fluid 312 that vaporizes and condenses to transfer heat rapidly from the base of the heat sink 404 where it contacts the semiconductor die 104 to its heat sink fins 406, where it is dissipated into the air. In various embodiments, a cooling fan 304 is used in conjunction with the heat sink 404 to facilitate the movement of air over the heat sink fins 406, thus enhancing the heat dissipation process. This combination is often referred to as an active heat sink, whereas a heat sink 404 without a fan is considered passive. Active heat sinks are required for semiconductor dies 104 with high thermal design power (TDP) because they generate more heat that needs to be efficiently dissipated to prevent overheating and maintain optimal performance. The design and efficiency of a heat sink 404 is important for keeping the semiconductor die 104 within safe operational temperatures, ensuring stability, and maximizing the lifespan of the hardware. Proper thermal management, including the use of a heat sink 404, is essential for high-performance computing, gaming, and any application where processors are subject to heavy loads.

The heat sink 404 includes a plurality of heat sink fins 406 and a fluid pipe 412 embedded in a base of the heat sink 404. The heat sink 404 channels a cooling fluid 312 from a valve 310 through the fluid pipe 412 inside of the heat sink 404, where the cooling fluid 312 may flow through the heat sink 404 and heat the cooling fluid 312 flowing along the liquid cooling path 314 within the heat sink 404, to a valve 326. The valve 326 releases the heated cooling fluid 318 from the heat sink 404 to one or more other liquid cooling components of the transient liquid cooling system 302. The liquid cooling components may pump, filter, dissipate heat from, and chill the heated cooling fluid 318 to form the cooling fluid 312, where it is recirculated back to the valve 310 towards the heat sink 404. For example, the liquid cooling path 314 may include an input flow 408 and an output flow 410. The input flow 408 may direct the cooling fluid 312 into the valve 310 from the heat sink 404, through the fluid pipe 412 of the heat sink 404 as the chilled fluid cools the semiconductor die 104, and away from the semiconductor die 104 with the output flow 410 through the valve 326 from the heat sink 404. The heated cooling fluid 318 may then be forwarded to a pump and/or a filter (or other components) of the transient liquid cooling system 302 before recirculating back to the valve 310 towards the heat sink 404.

The cooling fluid 312 flows through the fluid pipe 412 of the heat sink 404 and it transfers the heat generated by the semiconductor die 104 onto the heat sink 404, which dissipates heat from the heated liquid into the ambient, or another separate liquid cooling component of the transient liquid cooling system 302. In one embodiment, for example, the heat sink 404 may be formed of a highly thermally conductive material, such as copper, aluminum, or the like. In one embodiment, for example, the heat sink 404 may have a thickness of approximately 5 millimeters (mm) to 20 mm.

In one embodiment, a TIM layer 402 may be disposed on the semiconductor die 104 to thermally and/or mechanically couple the semiconductor die 104 to the heat sink 404. Examples for the TIM layer 402 may comprise without limitation a polymer TIM (PTIM), an epoxy, a liquid phase sintering (LPS) paste, a solder paste, a solder TIM (STIM), and/or any other type of thermal interface material. Note that the TIM layer 402 may need to be a material compatible with the applicable liquids described herein.

FIG. 5 illustrates a cross-sectional view of a semiconductor device 500 of the semiconductor package 100 with a liquid cooling component 316 of the transient liquid cooling system 302. The semiconductor device 500 depicts a cross-sectional view of the package substrate 102 and the semiconductor die 104 mounted on the package substrate 102 of the semiconductor package 100. In one embodiment, as illustrated in FIG. 5, the semiconductor device 500 does not use a protective enclosure 106. However, other embodiments may optionally use a protective enclosure 106 for the semiconductor device 500 for a given implementation. Embodiments are not limited in this context.

In addition to the package substrate 102 and the semiconductor die 104, the semiconductor device 500 comprises additional thermal management components, such as a TIM layer 402 and a cold plate 502. The thermal management components of the semiconductor package 100 implement a liquid cooling solution that enables targeted cooling of the semiconductor die 104 and/or the entire semiconductor package 100. For example, the semiconductor package 100 may implement a liquid cooling technique such as direct liquid cooling and/or liquid immersion cooling. The cooling fluid 312 flows throughout the semiconductor package 100 along one or more liquid cooling paths, such as a liquid cooling path 314.

As described herein, a cooling fluid 508 may transfer heat from the semiconductor die 104 to the cold plate 502 which dissipates heat from the heated cooling fluid 318 into the ambient, or another separate liquid cooling component of the transient liquid cooling system 302.

As depicted in semiconductor device 500, the cold plate 502 is disposed over a top surface of the semiconductor die 104 mounted on the package substrate 102. The cold plate 502 includes a plurality of openings 504, a plurality of channels 506 (or micro-channels), an inlet opening 512, and an outlet opening 514. The cold plate 502 channels a cooling fluid 312 from an inlet opening 512 through the channels 506 inside of the cold plate 502, where the fluid may flow through the openings 504 and cool the channels 506 within the cold plate 502, to an outlet opening 514. The outlet opening 514 releases the cooling fluid 508 from the cold plate 502 to one or more other liquid cooling components of the transient liquid cooling system 302. The liquid cooling components may pump, filter, dissipate heat from, and chill the cooling fluid 312 before the cooling fluid 312 is recirculated back to the inlet opening 512 of the cold plate 502. For example, the liquid cooling path 314 may include an input flow 408 and an output flow 410. The input flow 408 may direct the cooling fluid 312 into the inlet opening 512 of the cold plate 502, through the channels 506 of the cold plate 502 as the chilled fluid cools the semiconductor die 104, and away from the semiconductor die 104 with the output flow 410 through the outlet opening 514 of the cold plate 502. The heated cooling fluid 318 may then be forwarded to a pump and/or a filter (or other components) of the transient liquid cooling system 302 before recirculating back to the inlet opening 512 of the cold plate 502.

The cooling fluid 312 flowing through the cold plate 502 transfers the heat generated by the semiconductor die 104 onto the cold plate 502, which dissipates heat from the heated cooling fluid 318 into the ambient, or another separate liquid cooling component of the transient liquid cooling system 302. In one embodiment, for example, the cold plate 502 may be formed of a highly thermally conductive material, such as copper, aluminum, or the like. In one embodiment, for example, the cold plate 502 may have a thickness of approximately 5 millimeters (mm) to 20 mm.

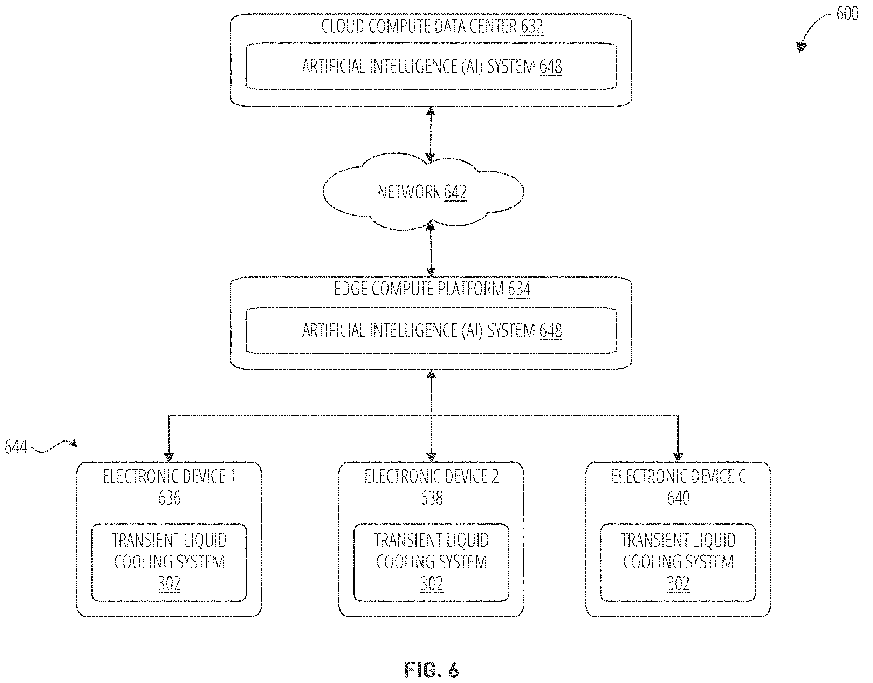

FIG. 6 illustrates an edge computing system 600. Edge computing system 600 is an example architecture for a system comprising a set of electronic devices suitable for implementing the apparatus 300, semiconductor system 400, and/or semiconductor device 500. Specifically, the edge computing system 600 is an example architecture for an edge computing system utilizing various electronic devices implementing the transient liquid cooling system 302 as described herein.

As depicted in FIG. 6, the edge computing system 600 comprises a cloud compute data center 632 and an edge compute platform 634 communicating through a network 642. The edge compute platform 634 may offer edge services to a set of electronic devices 644, such as electronic device 1 636, electronic device 2 638, and electronic device C 640, where C represents any positive integer.

The cloud compute data center 632 is a facility used by cloud service providers to house computer systems and associated components, such as telecommunications and storage systems, that support the delivery of cloud services. These cloud compute data centers 632 are the backbone of cloud computing, enabling the virtualized and scalable resources offered as services over the internet or dedicated networks. They comprise servers, storage devices, networking equipment, and software that together provide a range of services, including software as a service (SaaS), platform as a service (PaaS), and infrastructure as a service (IaaS). The cloud compute data center 632 allows physical server hardware to run multiple server environments or instances simultaneously, increasing resource utilization and efficiency. The cloud compute data center 632 supports the ability to scale resources up or down as needed, allowing users to dynamically adjust computing power, storage, and bandwidth according to demand. The cloud compute data center 632 increases reliability achieved through redundancy and fault tolerance mechanisms, ensuring high availability and continuity of service even in the event of hardware failure or other issues. The cloud compute data center 632 includes multiple layers of security controls, such as firewalls, intrusion detection systems, and data encryption, to protect data and operations against unauthorized access and cyber threats. The cloud compute data center 632 offer connectivity through high-bandwidth network connections to facilitate quick access to applications, data, and services hosted in the data center from anywhere in the world.

The edge compute platform 634 is a distributed computing platform that brings computation and data storage closer to the location where it is needed, to improve response times and save bandwidth. The edge compute platform 634 is designed to perform data processing at the edge of the network, near the source of data generation, rather than relying solely on a centralized data processing facility, such as the cloud compute data center 632. This approach is particularly beneficial in scenarios where low latency, high bandwidth, or local data analysis and processing are required. The edge compute platform 634 provides close proximity to data sources. Edge computing devices are located close to IoT devices, sensors, or other data sources, enabling data to be processed locally instead of being transmitted to a distant server or cloud for analysis. By processing data locally, edge compute platforms 634 significantly reduce the latency involved in sending data to and from the cloud, leading to faster decision-making and action based on the analyzed data. Local data processing helps to reduce the amount of data that must be sent over the network, conserving bandwidth and reducing reliance on constant connectivity to centralized cloud services. Edge computing allows for scalable deployment of applications by distributing processing tasks across numerous edge nodes. Processing data locally can help address privacy concerns and comply with data sovereignty regulations, as sensitive information does not have to leave the local site. Edge compute platforms 634 may include a variety of technologies like edge servers, IoT devices, and mobile computing devices. They support a wide range of applications, from autonomous vehicles and smart cities to industrial Internet of Things (IoT) and content delivery networks.

One or more of the electronic devices 644 may implement one or more semiconductor dies 104 using the transient liquid cooling system 302 for thermal management to cool the semiconductor dies 104 on an as-needed basis. The electronic devices 644 may comprise any type of electronic device suitable for working with an edge computing system 600. The electronic devices 644 often have the capability to either process data locally or to serve as the source or endpoint of data in edge environments. Non-limiting examples of electronic devices 644 include: smartphones and tablets which have powerful processing capabilities and therefore can handle significant computational tasks locally, reducing the need to send data back and forth to the cloud compute data center 632; IoT sensors that gather data from the environment such as temperature sensors, motion detectors, and cameras, can preprocess data before sending it on or make local decisions; industrial controllers used in manufacturing and industrial settings, including programmable logic controllers (PLCs) and industrial PCs that can perform real-time processing at the edge; wearable devices such as smartwatches and health monitors, which can process health and fitness data directly on the device; autonomous vehicles such as cars, drones, and robots that require real-time processing to navigate and interact with their environment efficiently; edge servers which are dedicated hardware located on-premises or near the data source to perform heavier data processing tasks that sensors or smaller devices cannot handle; smart home devices including smart thermostats, lights, and security systems that can process data locally to perform actions without relying on a central server; network gateways which are devices that connect different networks and process data as it passes through, often adding an additional layer of security or data filtering; medical devices such as portable diagnostic devices or patient monitoring equipment that require real-time data processing to provide timely insights; retail Point-of-Sale (POS) systems that can process sales transactions locally to reduce latency and continue operating even in the event of network failures. The suitability of these devices for edge computing depends on their ability to process data locally, their connectivity options, and their capacity to make decisions or take actions based on processed data without always needing to communicate with a central cloud-based system. Advancements in semiconductor technology, artificial intelligence (AI), and machine learning algorithms continue to expand the capabilities and applications of edge computing devices.

In various embodiments, the cloud compute data center 632 and/or the edge compute platform 634 may implement some or all of an AI system 648. The AI system 648 may assist in delivery of various edge services, including control, management, and orchestration of the transient liquid cooling system 302 for one or more of the electronic devices 644. In general, the AI system 648 is a computerized system designed to perform tasks that typically require human intelligence. These tasks include understanding natural language, recognizing patterns in data, making decisions based on complex or incomplete information, and learning or improving performance over time based on experience. The AI system 648 is built on a combination of algorithms, software, and, in some cases, specialized hardware that enables them to process and analyze vast amounts of data much faster and more efficiently than human beings can. The AI system 648 may implement various machine learning (ML) algorithms to train ML models that allow the system to learn from and make predictions or decisions based on data, without being explicitly programmed for specific tasks. The AI system 648 may include various machine or computer components (e.g., circuit, processor circuit, memory, network interfaces, compute platforms, input/output (I/O) devices, etc.) for an AI/ML system that are designed to work together to create a pipeline that can take in raw data, process it, train an ML model, evaluate performance of the trained ML model, and deploy the tested ML model as a trained ML model in a production environment, and continuously monitor and maintain it.

In one embodiment, for example, the AI system 648 implements a ML algorithm to train an ML model using a training dataset generated from historical information associated with thermal management operations of the cloud compute data center 632, the edge compute platform 634, and/or the electronic devices 644. The ML model accepts as input sensor data (e.g., ambient temperatures, processing loads, time of day, seasons, etc.) collected from the various sensors 324 of the transient liquid cooling system 302, analyzes the sensor data for patterns, and generates a prediction of the likelihood of getting closer to a DTR limit for a semiconductor die 104. The ML model may comprise, for example, an artificial neural network (ANN), such as a long short-term memory (LSTM) neural network. When the ML model predicts that a semiconductor die 104 is approaching a DTR limit or DTR zone, the ML model sends a control directive to the controller 320 of the transient liquid cooling system 302 to activate liquid cooling of the semiconductor die 104.

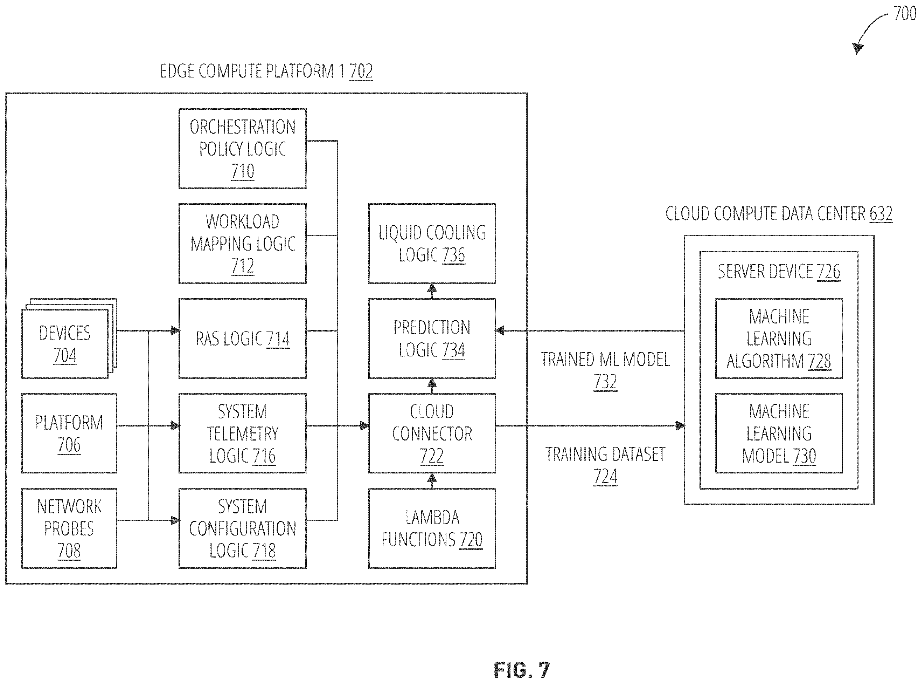

FIG. 7 illustrates an edge computing system 700. Edge computing system 700 is an example architecture for a system comprising a set of electronic devices suitable for implementing the apparatus 300, semiconductor system 400, semiconductor device 500, and/or edge computing system 600. Specifically, the edge computing system 700 is a cloud computing architecture for an edge computing system utilizing a distributed AI system 648 to manage and control the transient liquid cooling systems 302 of the various electronic devices 644 as described herein.

As depicted in FIG. 7, the edge computing system 700 comprises the cloud compute data center 632 and an edge compute platform 1 702 communicating through the network 642. The edge compute platform 1 702 is an example of the edge compute platform 634 as described with reference to FIG. 6. As with the edge compute platform 634, the edge compute platform 1 702 may offer edge services to a set of electronic devices 644, such as electronic device 1 636, electronic device 2 638, and electronic device C 640, for example.

The edge compute platform 1 702 comprises a set of devices 704. The devices 704 may comprise, discrete electronic devices 644, such as edge devices. An edge device in the context of edge computing is a piece of hardware that controls data flow at the boundary between two networks. These devices are used for processing, collecting, and analyzing data near the source of data generation, rather than sending the data across a network to a data center or cloud for processing. This proximity to data sources allows for real-time, or near real-time, computing and decision-making, reducing latency and bandwidth use. Edge devices can range from simple sensors and actuators to more complex computing devices like smart routers, IoT devices, smartphones, and gateways. The key characteristic of an edge device is its ability to perform local computation on the data it collects before potentially sending it on to central data centers or clouds for further processing or storage, such as cloud compute data center 632, for example.

The edge compute platform 1 702 comprises a platform 706. The platform 706 is a suite of tools and technologies designed to facilitate the development, deployment, management, and operation of applications and services at the edge of the network. An edge platform aims to streamline the complexities associated with edge computing, such as handling heterogeneous devices, managing distributed data, ensuring security, and optimizing resources across various edge locations. To this end, the platform 706 may include software and hardware supporting: development tools to create edge applications, an execution environment for running edge applications which could involve containerization or virtualization technologies to ensure applications are portable and isolated from one another; data management capabilities for efficiently handling data at the edge such as data collection, processing, aggregation, and potentially synchronization with centralized cloud services or data centers; networking interfaces for secure and reliable communication between edge devices, and between edge devices and central systems, possibly incorporating features like network slicing for bandwidth optimization; device management tools for remotely managing and configuring edge devices, including software updates, monitoring, and fault management to ensure the health and security of the edge infrastructure; and integrated security features to protect the edge platform and its devices from cyber threats, such as encryption, identity and access management, and intrusion detection systems.

The edge compute platform 1 702 comprises a set of network probes 708. The network probes 708 are devices or software tools designed to actively monitor, analyze, and collect data about the network's performance and health. The network probes 708 are strategically deployed at various points within an edge computing infrastructure to gather real-time metrics such as bandwidth usage, latency, packet loss, and overall network traffic patterns. Their primary objective is to ensure the optimal operation of the network, which is critical for the functionality and efficiency of edge computing systems where data is processed close to the source of generation. The network probes 708 perform functions such as measuring various performance metrics to identify potential bottlenecks or degradation in network service levels that could impact edge applications, detecting and diagnosing network problems and failures proactively to minimize downtime and service disruption, monitoring network traffic for unusual patterns or activities that could indicate security threats such as intrusions or malware spreading within the edge infrastructure, providing insights into the type, volume, and flow of data across the network to aid in capacity planning, network optimization, and ensuring quality of service for critical applications, assisting in the deployment of new network configurations, updates, or patches by validating their performance and ensuring they do not adversely affect the network.

The edge compute platform 1 702 also includes a set of components and/or devices to implement various types of logic for supporting various edge services and features. For example, the edge compute platform 1 702 includes an orchestration policy logic 710, a workload mapping logic 712, a RAS logic 714 (reliability-availability-serviceability), a system telemetry logic 716, and a system configuration logic 718. The orchestration policy logic 710 implements one or more orchestration policies for the edge computing system 700. An orchestration policy comprises a set of rules or guidelines designed to manage and coordinate the configuration, provision, and deployment of resources and services across an edge computing environment. These policies enable automated decision-making regarding where, when, and how computing tasks are executed within the distributed framework of an edge network, taking into account factors like resource availability, network conditions, application requirements, and security constraints. The workload mapping logic 712 implements algorithms or methodologies used to determine how and where various computing tasks or workloads are assigned and executed within an edge computing architecture. This logic is used for maximizing the efficiency, performance, and reliability of an edge network by ensuring that workloads are processed in the most appropriate location, taking into account factors such as the type of task, resources required, latency constraints, and network traffic conditions. The RAS logic 714 implements logic for reliability, availability, and serviceability (RAS) attributes for systems operating at the edge of a network due to their often remote, autonomous nature and their need for high reliability in processing data near its source. The system telemetry logic 716 manages system telemetry data for an edge system, which includes the automated collection, transmission, and analysis of data regarding the performance, health, and behavior of the computing devices, software, and networks that constitute the edge computing environment. This data is used for monitoring, managing, and optimizing system performance and ensuring the reliability and security of edge operations. The system configuration logic 718 controls setup and management of hardware, software, network settings, and policies that determine how an edge computing environment operates. This includes specifying and arranging the components of the system to work together efficiently to process, store, and transmit data as intended.

Further, the edge computing system 700 depicts an example of the edge compute platform 1 702 and the cloud compute data center 632 implementing various types of logic and components of the AI system 648. As depicted in the edge computing system 700, the edge compute platform 1 702 may implement a set of lambda functions 720, a cloud connector 722, prediction logic 734, and liquid cooling logic 736. The cloud compute data center 632 may implement logic for an ML algorithm 728 and an ML model 730.

The edge compute platform 1 702 may implement a set of one or more lambda functions 720. A lambda function is a relatively small, anonymous function defined with the lambda keyword in programming languages like Python. It is often used in machine learning code for conciseness and flexibility, especially in data manipulation and feature engineering phases. A lambda function in Python allows the function to take any number of arguments but comprises only one expression, the result of which is returned by the function. In machine learning, Lambda functions are frequently used in data preprocessing steps to apply transformations to data elements. For example, a lambda function may convert temperatures from Celsius to Fahrenheit across a dataset. When creating or modifying features in a dataset, lambda functions can apply quick, inline calculations or transformations without the need for defining a separate, named function. Lambda functions are often used with map(), filter(), and reduce() functions to apply operations on lists or columns in a DataFrame. For instance, applying a lambda function to scale a numerical feature in a pandas DataFrame column.

The edge compute platform 1 702 may implement the lambda functions 720 to preprocess data from various logic or components of the edge compute platform 1 702, such as the orchestration policy logic 710, the workload mapping logic 712, the RAS logic 714, and system telemetry logic 716, and/or the system configuration logic 718. The output of the lambda functions 720 is a training dataset 724 suitable for training an ML model, such as the ML model 730 of the cloud compute data center 632. The cloud connector 722 collects the output from the lambda functions 720, employs a set of filters to filter the output from the lambda functions 720 to limit the output to a dataset suitable for inclusion in the training dataset 724, and outputs the training dataset 724 to a server device 726 of the cloud compute data center 632.

The cloud compute data center 632 comprises a set of servers, such as a server pool or server farm, as represented by the server device 726. The server device 726 executes an ML algorithm 728 to train an ML model 730 using the training dataset 724. Once the ML model 730 is trained, the server device 726 sends a trained ML model 732 to the edge compute platform 1 702 for deployment by the prediction logic 734 to perform inferencing operations to support the liquid cooling logic 736.

The ML model 730 is a mathematical construct used to predict outcomes based on a set of input data. The ML model 730 is trained using large volumes of training data from the training dataset 724, and it can recognize patterns and trends in the training data to make accurate predictions. The ML model 730 is derived from an ML algorithm 728. The training dataset 724 is fed into the ML algorithm 728 which trains the ML model 730 to "learn" a function that produces mappings between a set of inputs and a set of outputs with a reasonably high accuracy. Given a sufficiently large enough set of inputs and outputs, the ML algorithm 728 finds the function for a given task. This function may even be able to produce the correct output for input that it has not seen during training. A data scientist prepares the mappings, selects and tunes the ML algorithm 728, and evaluates the resulting model performance. Once the ML model 730 is sufficiently accurate on test data, it can be deployed for production use.

The ML algorithm 728 may comprise any ML algorithm suitable for a given AI task. Examples of ML algorithms may include supervised algorithms, unsupervised algorithms, semi-supervised algorithms, or reinforcement learning algorithms.

A supervised algorithm is a type of machine learning algorithm that uses labeled data to train a machine learning model. In supervised learning, the machine learning algorithm is given a set of input data and corresponding output data, which are used to train the model to make predictions or classifications. The input data is also known as the features, and the output data is known as the target or label. The goal of a supervised algorithm is to learn the relationship between the input features and the target labels, so that it can make accurate predictions or classifications for new, unseen data. Examples of supervised learning algorithms include: (1) linear regression which is a regression algorithm used to predict continuous numeric values, such as stock prices or temperature; (2) logistic regression which is a classification algorithm used to predict binary outcomes, such as whether a customer will purchase or not purchase a product; (3) decision tree which is a classification algorithm used to predict categorical outcomes by creating a decision tree based on the input features; or (4) random forest which is an ensemble algorithm that combines multiple decision trees to make more accurate predictions.

An unsupervised algorithm is a type of machine learning algorithm that is used to find patterns and relationships in a dataset without the need for labeled data. Unlike supervised learning, where the algorithm is provided with labeled training data and learns to make predictions based on that data, unsupervised learning works with unlabeled data and seeks to identify underlying structures or patterns. Unsupervised learning algorithms use a variety of techniques to discover patterns in the data, such as clustering, anomaly detection, and dimensionality reduction. Clustering algorithms group similar data points together, while anomaly detection algorithms identify unusual or unexpected data points. Dimensionality reduction algorithms are used to reduce the number of features in a dataset, making it easier to analyze and visualize. Unsupervised learning has many applications, such as in data mining, pattern recognition, and recommendation systems. It is particularly useful for tasks where labeled data is scarce or difficult to obtain, and where the goal is to gain insights and understanding from the data itself rather than to make predictions based on it.

Semi-supervised learning is a type of machine learning algorithm that combines both labeled and unlabeled data to improve the accuracy of predictions or classifications. In this approach, the algorithm is trained on a small amount of labeled data and a much larger amount of unlabeled data. The main idea behind semi-supervised learning is that labeled data is often scarce and expensive to obtain, whereas unlabeled data is abundant and easy to collect. By leveraging both types of data, semi-supervised learning can achieve higher accuracy and better generalization than either supervised or unsupervised learning alone. In semi-supervised learning, the algorithm first uses the labeled data to learn the underlying structure of the problem. It then uses this knowledge to identify patterns and relationships in the unlabeled data, and to make predictions or classifications based on these patterns. Semi-supervised learning has many applications, such as in speech recognition, natural language processing, and computer vision. It is particularly useful for tasks where labeled data is expensive or time-consuming to obtain, and where the goal is to improve the accuracy of predictions or classifications by leveraging large amounts of unlabeled data.

Reinforcement Learning is a type of machine learning paradigm that is primarily concerned with how agents ought to take actions in an environment to maximize the cumulative reward. Unlike supervised learning where models are trained on a dataset containing inputs paired with correct outputs, reinforcement learning involves an agent that interacts with its environment to learn the best actions to take in different states through trial and error. In a reinforcement learning system, an agent is the learner or decision-maker that takes actions and the environment is the world through which the agent moves and learns from the consequences of its actions. State is a representation of the current situation of the agent in the environment. The state space can be the set of all possible situations the agent can face. Actions are all the possible moves that the agent can make. The set of actions available can depend on the state. 5. Reward is signal from the environment in response to the agent's action, indicating the value of the action taken. The agent's objective is to maximize the cumulative reward over time. Policy sets a strategy used by the agent, mapping states to actions, that dictates the action an agent takes in a given state. A value function estimates the expected cumulative reward of taking an action in a state, following a particular policy. It helps in evaluating the goodness of each state and deciding the next action. A model is a representation of the environment that can predict how the environment will respond to an agent's actions. In model-based reinforcement learning, the agent uses it to plan by considering future possibilities, while in model-free reinforcement learning, the agent learns exclusively from trial and error. The learning process in RL involves exploration (trying out new actions to discover their effects) and exploitation (using known information to make the best decision). Reinforcement learning algorithms are categorized into various approaches, such as value-based methods, policy-based methods, and actor-critic methods. Value-based methods focus on learning the value function, with Q-Learning being a prominent example. Policy-based methods involve directly learning the policy function that maps states to the optimal actions without requiring a value function. Actor-critic methods combine value-based and policy-based methods by using two models, with one to determine the action to take (actor) and another to evaluate the action (critic). Reinforcement learning is used in a wide range of applications, from game playing and robotics to recommendation systems and autonomous vehicles, where the challenge is to make a sequence of decisions that will lead to an optimal outcome.

The ML algorithm 728 of the AI system 648 is implemented using various types of ML algorithms including supervised algorithms, unsupervised algorithms, semi-supervised algorithms, reinforcement learning algorithms, or a combination thereof. A few examples of ML algorithms include support vector machine (SVM), random forests, naive Bayes, K-means clustering, neural networks, and so forth. A SVM is an algorithm that can be used for both classification and regression problems. It works by finding an optimal hyperplane that maximizes the margin between the two classes. Random forests is a type of decision tree algorithm that is used to make predictions based on a set of randomly selected features. Naive Bayes is a probabilistic classifier that makes predictions based on the probability of certain events occurring. K-Means Clustering is an unsupervised learning algorithm that groups data points into clusters. Neural networks is a type of machine learning algorithm that is designed to mimic the behavior of neurons in the human brain. Other examples of ML algorithms include a support vector machine (SVM) algorithm, a random forest algorithm, a naive Bayes algorithm, a K-means clustering algorithm, a neural network algorithm, an artificial neural network (ANN) algorithm, a convolutional neural network (CNN) algorithm, a recurrent neural network (RNN) algorithm, a long short-term memory (LSTM) algorithm, a deep learning algorithm, a decision tree learning algorithm, a regression analysis algorithm, a Bayesian network algorithm, a genetic algorithm, a federated learning algorithm, a distributed artificial intelligence algorithm, and so forth. Embodiments are not limited in this context.

Once the ML algorithm 728 sufficiently trains and tests the ML model 730, the server device 726 sends the trained ML model 732 to the edge compute platform 1 702 for deployment by the prediction logic 734.

The prediction logic 734 receives as input data from one or more outputs of the various types of logic implemented by the edge compute platform 1 702, such as the orchestration policy logic 710, the workload mapping logic 712, the RAS logic 714, the system telemetry logic 716, and/or the system configuration logic 718. The prediction logic 734 analyzes the input data, and it generates a prediction for the transient liquid cooling system 302. For example, the prediction logic 734 generates a prediction of a DTR limit, such as a first threshold value to trigger activation of the transient liquid cooling system 302 to increase cooling for a semiconductor die 104 of one or more electronic devices 644, or a second threshold value to trigger deactivation of the transient liquid cooling system 302 to decrease cooling for the semiconductor die 104 of the one or more electronic devices 644. The DTR limits may change over time as the training dataset 724 is updated with new training data, and the ML algorithm 728 re-trains the ML model 730 with the updated training dataset 724. This feedback loop ensures the predictions for DTR limits are periodically updated with current data, thereby increasing accuracy of the predictions made by the prediction logic 734. The prediction logic 734 outputs the predictions to the liquid cooling logic 736.

The liquid cooling logic 736 manages liquid cooling operations for one or more transient liquid cooling systems 302 for one or more semiconductor dies 104 implemented by one or more electronic devices 644. Operations of the liquid cooling logic 736 is similar to the liquid cooling logic 322 of the transient liquid cooling system 302, except it operates on a system level rather than a device level or component level.

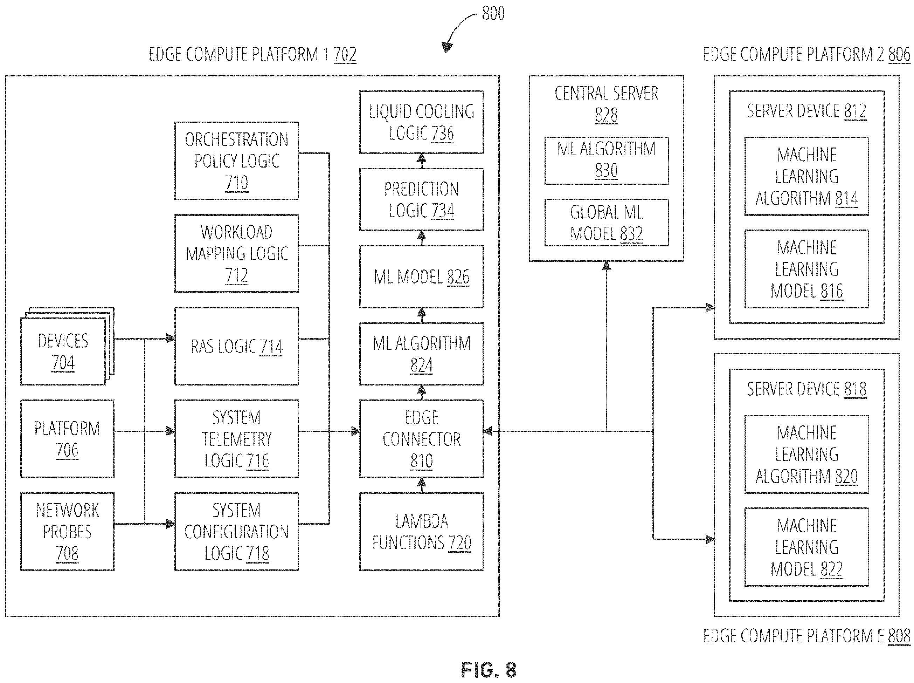

FIG. 8 illustrates an edge computing system 800. Edge computing system 800 is an example architecture for a system comprising a set of electronic devices suitable for implementing the apparatus 300, semiconductor system 400, semiconductor device 500, edge computing system 600, and/or edge computing system 700. Specifically, the edge computing system 800 is a more detailed example of a federated architecture for an edge computing system utilizing a distributed AI system 648 to manage and control the transient liquid cooling systems 302 of the various electronic devices 644 as described herein.

As depicted in FIG. 8, the edge computing system 800 comprises multiple edge computing edge compute platforms 634 operating together in a federated model. For example, the edge computing system 800 comprises an edge compute platform 1 702, an edge compute platform 2 806, and an edge compute platform E 808, where E represents any positive integer, all communicating through the network 642. As with the edge compute platform 1 702, the edge compute platform 2 806 and the edge compute platform E 808 may offer edge services to a set of electronic devices 644, such as electronic device 1 636, electronic device 2 638, and electronic device C 640, in different geographic regions or locations.

A federated model for an edge system refers to the implementation of Federated Learning (FL) in an edge computing environment. Federated Learning is a machine learning approach that enables a model to be trained across multiple decentralized edge devices or servers holding local data samples, without exchanging them. This method addresses privacy concerns, reduces the need for large centralized data storage, and minimizes the bandwidth needed to transmit large datasets. In an edge computing context, federated models leverage the computation and data storage capabilities of edge devices (such as smartphones, IoT devices, and edge servers) to perform local computations on data. These devices work collaboratively to improve a shared machine learning model by keeping the data localized, thereby enhancing privacy and efficiency. A federated model provides several advantages for an edge system. For example, data remains on the device, reducing the risk of privacy breaches. Only model updates are transmitted, not the raw data, significantly reducing the amount of data sent over the network. Federated learning can easily scale to accommodate more devices without a significant increase in central processing or storage requirements. Models can learn from data in real-time, adapting to new data trends and patterns as they occur in the edge environment. Federated models are particularly useful in scenarios where privacy is paramount, and the data is naturally decentralized, such as in healthcare, finance, telecommunications, and smart cities. Implementing federated learning in edge systems poses unique challenges, including handling device heterogeneity, dealing with uneven data distribution (data bias), and ensuring robust and secure model aggregation methods.

As depicted in FIG. 8, the edge computing system 800 comprises a central server 828 and multiple edge compute platforms 634. Each edge compute platform 634 may have an architecture similar to that shown for the edge compute platform 1 702. Further, each edge compute platform 634 may implement hardware and software components for an AI system 648. For example, the edge compute platform 1 702 implements a set of lambda functions 720, an edge connector 810, an ML algorithm 824, an ML model 826, prediction logic 734, and liquid cooling logic 736. The edge connector 810, the ML algorithm 824 and the ML model 826 are similar to the cloud connector 722, the ML algorithm 728, and the ML model 730 as described with reference to FIG. 7. Similarly, the edge compute platform 2 806 implements a server device 812 for executing an ML algorithm 814 and an ML model 816, while the edge compute platform E 808 implements a server device 818 for executing an ML algorithm 820 and an ML model 822. The ML algorithm 814 and the ML algorithm 820 are similar to the ML algorithm 728, and the ML model 816 and ML model 822 are similar to the ML model 730.

The central server 828 implements an ML algorithm 830 and a global ML model 832. The ML algorithm 830 initializes and distributes the global ML model 832 to participating edge devices, such as edge compute platform 1 702, the edge compute platform 2 806, and the edge compute platform E 808, from the central server 828. Each edge device trains the model on its local data, creating a set of model updates that reflect the learning from that data. The model updates from all participating devices are sent back to the central server 828, where they are aggregated to produce an updated global ML model 832. This aggregation can be done in ways that further preserve privacy, such as using secure aggregation techniques. The updated global ML model 832 is then sent back to the edge devices, replacing the local models, and the process repeats for several cycles until the model converges or meets the desired performance criteria. For example, a trained version of the global ML model 832 is deployed as the ML model 826 for use by the prediction logic 734 to make predictions for DTR limits. The prediction logic 734 outputs the predicted DTR limits to the liquid cooling logic 736 for controlling and managing operations of the transient liquid cooling systems 302 for the semiconductor dies 104 of the electronic devices 644.

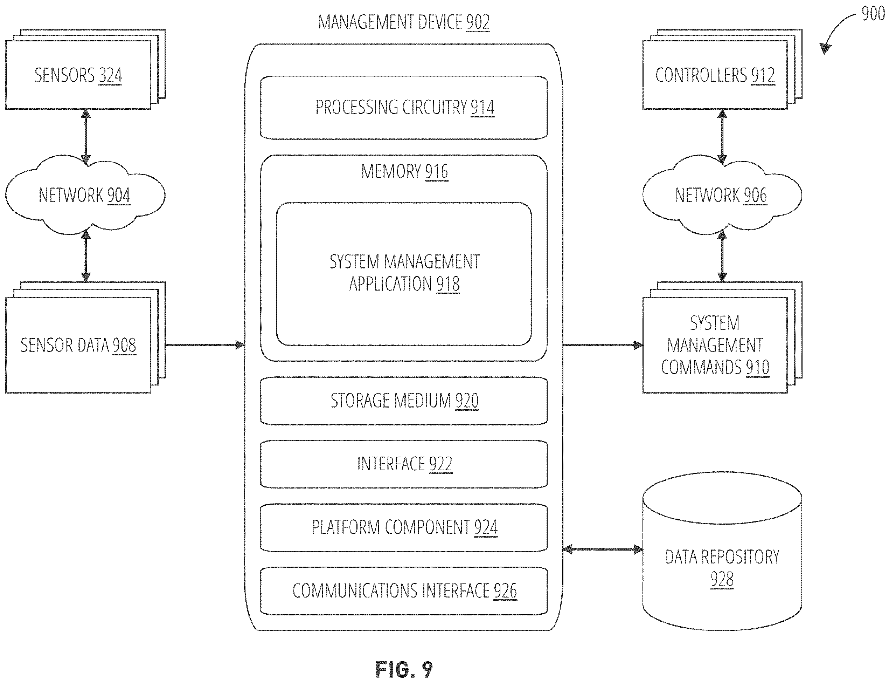

FIG. 9 illustrates an embodiment of a system 900. The system 900 is suitable for implementing one or more embodiments as described herein. In one embodiment, for example, the system 900 implements a management device 902 for receiving and decoding sensor data 908 from one or more sensors 324 of the apparatus 300, the semiconductor system 400, the semiconductor device 500, the edge computing system 600, the edge computing system 700, and/or the edge computing system 800. The management device 902 analyzes the sensor data 908, and sends one or more system management commands 910 to the controllers 912, such as the controller 320, of the transient liquid cooling systems 302 for thermal management of the semiconductor dies 104 of the electronic devices 644.

The system 900 comprises a set of *M* devices, where *M is* any positive integer. FIG. 9 depicts three devices (M=3), including a set of sensors 324, a management device 902, and a set of controllers 912. The management device 902 communicates information with the sensors 324 and the controllers 912 over a network 904 and a network 906, respectively. The information may include sensor data 908 from the sensors 324 and system management commands 910 to the controllers 912.

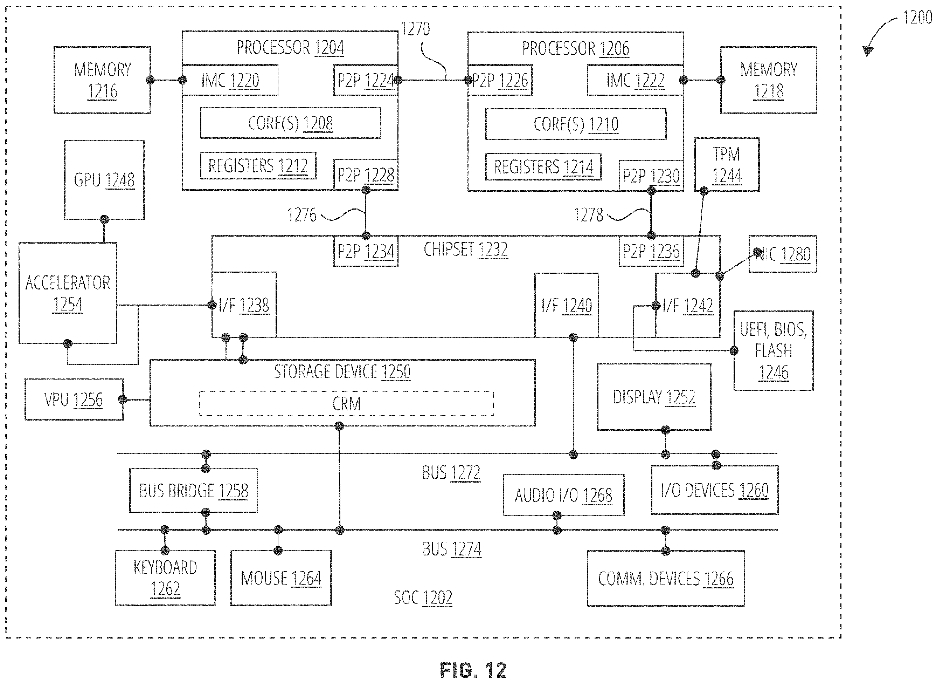

As depicted in FIG. 9, the management device 902 includes processing circuitry 914, a memory 916, a storage medium 920, an interface 922, and a platform component 924. In some implementations, the management device 902 includes other components or devices as well. Examples for software elements and hardware elements of the management device 902 are described in more detail with reference to a computing architecture 1200 as depicted in FIG. 12. Embodiments are not limited to these examples.

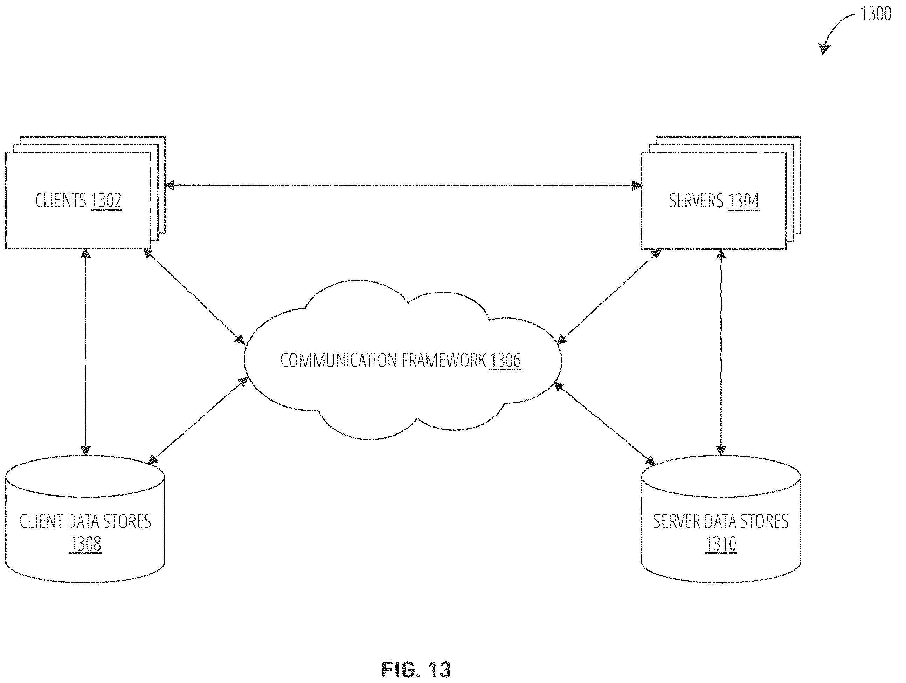

The management device 902 is generally arranged to receive sensor data 908, process the sensor data 908 via one or more analysis techniques, and send system management commands 910. The management device 902 receives the sensor data 908 from the sensors 324 via the network 904. The management device 902 sends the system management commands 910 to the controllers 912 via the network 906, the platform component 924 (e.g., a touchscreen as a text command or microphone as a voice command), the system management application 918, the memory 916, the storage medium 920, or the data repository 928. Examples for the software elements and hardware elements of the network 904 and the network 906 are described in more detail with reference to a communications architecture 1300 as depicted in FIG. 13. Embodiments are not limited to these examples.

In one embodiment, the controllers 912 control various internal electronic components and/or internal cooling components of the transient liquid cooling system 302. For example, the system management application 918 may generate system management commands 910. For instance, a system operator or an automated system may use the system management application 918 to generate command and control directives for the transient liquid cooling system 302 in response to measurements received from the one or more sensors 324. Examples of system management commands 910 include a set of control directives, such as a first control directive for the transient liquid cooling system 302 to start delivery of the cooling fluid 312 from the fluid reservoir 306 to the liquid cooling component 316 of the semiconductor die 104 to reduce the temperature (Tj) of the semiconductor die 104. At some time after the start of delivery of the cooling fluid 312, the controller 320 detects the temperature of the semiconductor die 104 approaches or meets a second threshold value of the DTR 214 for the semiconductor die 104, where the second threshold value is lower than the first threshold value of the DTR 214. The liquid cooling logic 322 of the controller 320 generates a second control directive to stop delivery of the cooling fluid 312 from the fluid reservoir 306 to the liquid cooling component of the semiconductor die 104.

In one embodiment, for example, the first control directive includes a set of instructions, the set of instructions comprising a first instruction to open the first valve 310 of the fluid reservoir 306, a second instruction to open the second valve 326 of the heat exchanger 308, a third instruction to the first pump 328 to deliver the cooling fluid 312 from the fluid reservoir 306 to the liquid cooling component 316 of the semiconductor die 104 to absorb heat from the semiconductor die 104 to form heated cooling fluid 318, and a fourth instruction to the second pump 330 to deliver the heated cooling fluid 318 from the liquid cooling component 316 of the semiconductor die 104 to the heat exchanger 308 to remove heat from the heated cooling fluid 318.

In one embodiment, for example, the second control directive includes a set of instructions, the set of instructions comprising a first instruction to close the first valve 310 of the fluid reservoir 306, a second instruction to the first pump 328 to deliver the cooling fluid 312 to the liquid cooling component 316 of the semiconductor die 104 to absorb heat from the semiconductor die 104 to form heated cooling fluid 318, a third instruction to the second pump 330 to deliver the heated cooling fluid 318 from the liquid cooling component 316 of the semiconductor die 104 to the heat exchanger 308 to remove heat from the heated cooling fluid 318, and a fourth instruction to close the second valve 326 of the heat exchanger 308.

In one embodiment, for example, the liquid cooling logic 322 of the controller 320 may generate a third control directive to drain the cooling fluid 312 from the liquid cooling component 316 of the semiconductor die 104 back to the fluid reservoir 306. This may occur during storage or transport of a device implementing the semiconductor die 104, or to ensure that the cooling fluid 312 returns to a normal starting temperature prior to deployment in a next cooling cycle, for example. Embodiments are not limited to these examples.

Operations for the disclosed embodiments are further described with reference to the following figures. Some of the figures include a logic flow. Although such figures presented herein include a particular logic flow, the logic flow merely provides an example of how the general functionality as described herein is implemented. Further, a given logic flow does not necessarily have to be executed in the order presented unless otherwise indicated. Moreover, not all acts illustrated in a logic flow are required in some embodiments. In addition, the given logic flow is implemented by a hardware element, a software element executed by one or more processing devices, or any combination thereof. The embodiments are not limited in this context.

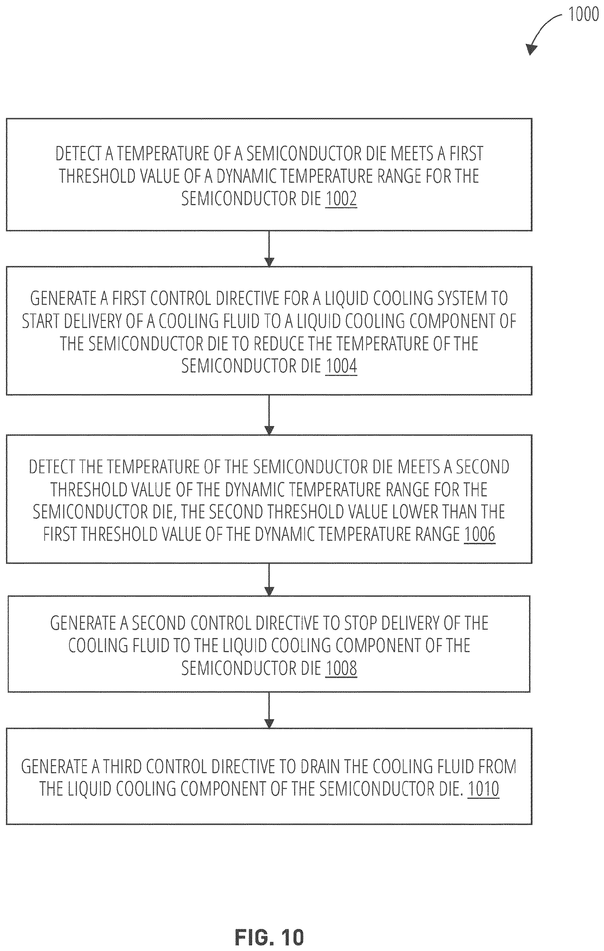

FIG. 10 illustrates an embodiment of a logic flow 1000. The logic flow 1000 is representative of some or all of the operations executed by one or more embodiments described herein. For example, the logic flow 1000 includes some or all of the operations performed by devices or entities within the semiconductor package 100, the operating environment 200, the apparatus 300, the semiconductor system 400, the semiconductor device 500, the edge computing system 600, the edge computing system 700, the edge computing system 800, and/or the system 900. In one embodiment, the logic flow 1000 is implemented as instructions stored on a non-transitory computer-readable storage medium, such as the storage medium 920, that when executed by the processing circuitry 914 causes the processing circuitry 914 to perform the described operations. The storage medium 920 and processing circuitry 914 may be co-located, or the instructions may be stored remotely from the processing circuitry 914. Collectively, the storage medium 920 and the processing circuitry 914 may form a system.

In block 1002, the logic flow 1000 detects a temperature of a semiconductor die meets a first threshold value of a dynamic temperature range for the semiconductor die. In block 1004, the logic flow 1000 generates a first control directive for a liquid cooling system to start delivery of a cooling fluid to a liquid cooling component of the semiconductor die to reduce the temperature of the semiconductor die. In block 1006, the logic flow 1000 detects the temperature of the semiconductor die meets a second threshold value of the dynamic temperature range for the semiconductor die, the second threshold value lower than the first threshold value of the dynamic temperature range. In block 1008, the logic flow 1000 generates a second control directive to stop delivery of the cooling fluid to the liquid cooling component of the semiconductor die. In block 1010, the logic flow 1000 generates a third control directive to drain the cooling fluid from the liquid cooling component of the semiconductor die.

By way of example, the apparatus 300 comprises a transient liquid cooling system 302 that includes a fluid reservoir 306 to store a cooling fluid 312. The transient liquid cooling system 302 also includes circuitry operably coupled to the liquid cooling system, such as a controller 320. The transient liquid cooling system 302 also includes memory operably coupled to the circuitry, the memory to store instructions for liquid cooling logic 322 that when executed by the circuitry causes the circuitry to detect a temperature (Tj) of a semiconductor die 104 via one or more sensors 324. When Tj meets a first threshold value of a DTR 214 for the semiconductor die 104, the controller 320 generates a first control directive for the transient liquid cooling system 302 to start delivery of the cooling fluid 312 from the fluid reservoir 306 to a liquid cooling component 316 of the semiconductor die 104 to reduce the temperature (Tj) of the semiconductor die 104. At some time after the start of delivery of the cooling fluid 312, the controller 320 detects the temperature of the semiconductor die 104 meets a second threshold value of the DTR 214 for the semiconductor die 104, where the second threshold value is lower than the first threshold value of the DTR 214. The controller 320 generates a second control directive to stop delivery of the cooling fluid 312 from the fluid reservoir 306 to the liquid cooling component of the semiconductor die 104.

The transient liquid cooling system 302 may further include a heat exchanger 308 (e.g., a radiator) and a cooling fan 304, a first valve 310 to control delivery of the cooling fluid 312 from the fluid reservoir 306, a second valve 326 to control delivery of heated cooling fluid 318 to the heat exchanger 308, a first pump 328 to deliver the cooling fluid 312 from the fluid reservoir 306 to the liquid cooling component 316 of the semiconductor die 104 to absorb heat from the semiconductor die 104 to form heated cooling fluid 318, and a second pump 330 to deliver the heated cooling fluid 318 from the liquid cooling component 316 of the semiconductor die 104 to the heat exchanger 308 to remove heat from the heated cooling fluid 318. Once the heat exchanger 308 removes heat from the heated cooling fluid 318 to form cooling fluid 312, it returns the cooling fluid 312 to the fluid reservoir 306.

The transient liquid cooling system 302 may further include the semiconductor die 104 mounted on a package substrate 102, a thermal interface material TIM layer 402 thermally coupled to the semiconductor die 104, and the liquid cooling component 316 thermally coupled to the thermal interface material TIM layer 402. The liquid cooling component 316 may be implemented as a heat sink or a cold plate thermally coupled to the semiconductor die 104, as described with reference to FIG. 4 and FIG. 5, respectively.

When Tj approaches or meets a first threshold value of a DTR 214 for the semiconductor die 104, the liquid cooling logic 322 of the controller 320 generates a first control directive for the transient liquid cooling system 302 to start delivery of the cooling fluid 312 from the fluid reservoir 306 to the liquid cooling component 316 of the semiconductor die 104 to reduce the temperature (Tj) of the semiconductor die 104. In one embodiment, for example, the first control directive includes a set of instructions, the set of instructions comprising a first instruction to open the first valve 310 of the fluid reservoir 306, a second instruction to open the second valve 326 of the heat exchanger 308, a third instruction to the first pump 328 to deliver the cooling fluid 312 from the fluid reservoir 306 to the liquid cooling component 316 of the semiconductor die 104 to absorb heat from the semiconductor die 104 to form heated cooling fluid 318, and a fourth instruction to the second pump 330 to deliver the heated cooling fluid 318 from the liquid cooling component 316 of the semiconductor die 104 to the heat exchanger 308 to remove heat from the heated cooling fluid 318.

At some time after the start of delivery of the cooling fluid 312, the controller 320 detects the temperature of the semiconductor die 104 approaches or meets a second threshold value of the DTR 214 for the semiconductor die 104, where the second threshold value is lower than the first threshold value of the DTR 214. The liquid cooling logic 322 of the controller 320 generates a second control directive to stop delivery of the cooling fluid 312 from the fluid reservoir 306 to the liquid cooling component of the semiconductor die 104. In one embodiment, for example, the second control directive includes a set of instructions, the set of instructions comprising a first instruction to close the first valve 310 of the fluid reservoir 306, a second instruction to the first pump 328 to deliver the cooling fluid 312 to the liquid cooling component 316 of the semiconductor die 104 to absorb heat from the semiconductor die 104 to form heated cooling fluid 318, a third instruction to the second pump 330 to deliver the heated cooling fluid 318 from the liquid cooling component 316 of the semiconductor die 104 to the heat exchanger 308 to remove heat from the heated cooling fluid 318, and a fourth instruction to close the second valve 326 of the heat exchanger 308.

In one embodiment, for example, the liquid cooling logic 322 of the controller 320 may generate a third control directive to drain the cooling fluid 312 from the liquid cooling component 316 of the semiconductor die 104 back to the fluid reservoir 306. This may occur during storage or transport of a device implementing the semiconductor die 104, or to ensure that the cooling fluid 312 returns to a normal starting temperature prior to deployment in a next cooling cycle, for example.

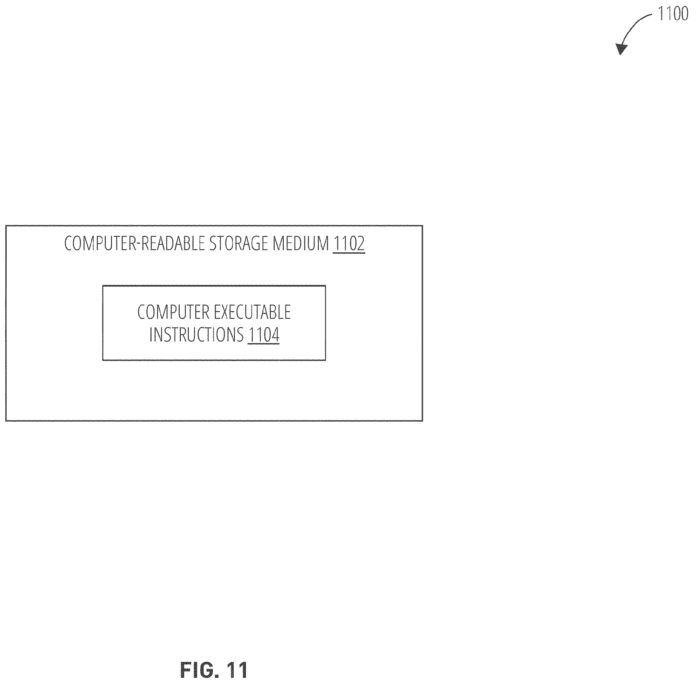

FIG. 11 illustrates an apparatus 1100. Apparatus 1100 comprises any non-transitory computer-readable storage medium 1102 or machine-readable storage medium, such as an optical, magnetic or semiconductor storage medium. In various embodiments, apparatus 1100 comprises an article of manufacture or a product. In some embodiments, the computer-readable storage medium 1102 stores computer executable instructions with which one or more processing devices or processing circuitry can execute. For example, computer executable instructions 1104 includes instructions to implement operations described with respect to any logic flows described herein. Examples of computer-readable storage medium 1102 or machine-readable storage medium include any tangible media capable of storing electronic data, including volatile memory or non-volatile memory, removable or non-removable memory, erasable or non-erasable memory, writeable or rewriteable memory, and so forth. Examples of computer executable instructions 1104 include any suitable type of code, such as source code, compiled code, interpreted code, executable code, static code, dynamic code, object-oriented code, visual code, and the like.

FIG. 12 illustrates an embodiment of a computing architecture 1200. Computing architecture 1200 is a computer system with multiple processor cores such as a distributed computing system, supercomputer, high-performance computing system, computing cluster, mainframe computer, mini-computer, client-server system, personal computer (PC), workstation, server, portable computer, laptop computer, tablet computer, handheld device such as a personal digital assistant (PDA), or other device for processing, displaying, or transmitting information. Similar embodiments may comprise, e.g., entertainment devices such as a portable music player or a portable video player, a smart phone or other cellular phone, a telephone, a digital video camera, a digital still camera, an external storage device, or the like. Further embodiments implement larger scale server configurations. In other embodiments, the computing architecture 1200 has a single processor with one core or more than one processor. Note that the term "processor" refers to a processor with a single core or a processor package with multiple processor cores. In at least one embodiment, the computing architecture 1200 is representative of the components of the system 900. More generally, the computing architecture 1200 is configured to implement all logic, systems, logic flows, methods, apparatuses, and functionality described herein with reference to previous figures.

As used in this application, the terms "system" and "component" and "module" are intended to refer to a computer-related entity, either hardware, a combination of hardware and software, software, or software in execution, examples of which are provided by the exemplary computing architecture 1200. For example, a component is, but is not limited to being, a process running on a processor, a processor, a hard disk drive, multiple storage drives (of optical and/or magnetic storage medium), an object, an executable, a thread of execution, a program, and/or a computer. By way of illustration, both an application running on a server and the server are a component. One or more components reside within a process and/or thread of execution, and a component is localized on one computer and/or distributed between two or more computers. Further, components are communicatively coupled to each other by various types of communications media to coordinate operations. The coordination involves the uni-directional or bi-directional exchange of information. For instance, the components communicate information in the form of signals communicated over the communications media. The information is implemented as signals allocated to various signal lines. In such allocations, each message is a signal. Further embodiments, however, alternatively employ data messages. Such data messages may be sent across various connections. Exemplary connections include parallel interfaces, serial interfaces, and bus interfaces.

As shown in FIG. 12, computing architecture 1200 comprises a system-on-chip (SoC) 1202 for mounting platform components. System-on-chip (SoC) 1202 is a point-to-point (P2P) interconnect platform that includes a first processor 1204 and a second processor 1206 coupled via a point-to-point interconnect 1270 such as an Ultra Path Interconnect (UPI). In other embodiments, the computing architecture 1200 is another bus architecture, such as a multi-drop bus. Furthermore, each of processor 1204 and processor 1206 are processor packages with multiple processor cores including core(s) 1208 and core(s) 1210, respectively. While the computing architecture 1200 is an example of a two-socket (2S) platform, other embodiments include more than two sockets or one socket. For example, some embodiments include a four-socket (4S) platform or an eight-socket (8S) platform. Each socket is a mount for a processor and may have a socket identifier. Note that the term platform refers to a motherboard with certain components mounted such as the processor 1204 and chipset 1232. Some platforms include additional components and some platforms include sockets to mount the processors and/or the chipset. Furthermore, some platforms do not have sockets (e.g. SoC, or the like). Although depicted as a SoC 1202, one or more of the components of the SoC 1202 are included in a single die package, a multi-chip module (MCM), a multi-die package, a chiplet, a bridge, and/or an interposer. Therefore, embodiments are not limited to a SoC.

The processor 1204 and processor 1206 are any commercially available processors, including without limitation an Intel^{®} Celeron^{®}, Core^{®}, Core (2) Duo^{®}, Itanium^{®}, Pentium^{®}, Xeon^{®}, and XScale^{®} processors; AMD^{®} Athlon^{®}, Duron^{®} and Opteron^{®} processors; ARM^{®} application, embedded and secure processors; IBM^{®} and Motorola^{®} DragonBall^{®} and PowerPC^{®} processors; IBM and Sony^{®} Cell processors; and similar processors. Dual microprocessors, multi-core processors, and other multi-processor architectures are also employed as the processor 1204 and/or processor 1206. Additionally, the processor 1204 need not be identical to processor 1206.

Processor 1204 includes an integrated memory controller (IMC) 1220 and point-to-point (P2P) interface 1224 and P2P interface 1228. Similarly, the processor 1206 includes an IMC 1222 as well as P2P interface 1226 and P2P interface 1230. IMC 1220 and IMC 1222 couple the processor 1204 and processor 1206, respectively, to respective memories (e.g., memory 1216 and memory 1218). Memory 1216 and memory 1218 are portions of the main memory (e.g., a dynamic random-access memory (DRAM)) for the platform such as double data rate type 4 (DDR4) or type 5 (DDR5) synchronous DRAM (SDRAM). In the present embodiment, the memory 1216 and the memory 1218 locally attach to the respective processors (i.e., processor 1204 and processor 1206). In other embodiments, the main memory couple with the processors via a bus and shared memory hub. Processor 1204 includes registers 1212 and processor 1206 includes registers 1214.

Computing architecture 1200 includes chipset 1232 coupled to processor 1204 and processor 1206. Furthermore, chipset 1232 are coupled to storage device 1250, for example, via an interface (I/F) 1238. The I/F 1238 may be, for example, a Peripheral Component Interconnect-enhanced (PCIe) interface, a Compute Express Link ^{®} (CXL) interface, or a Universal Chiplet Interconnect Express (UCIe) interface. Storage device 1250 stores instructions executable by circuitry of computing architecture 1200 (e.g., processor 1204, processor 1206, GPU 1248, accelerator 1254, vision processing unit 1256, or the like). For example, storage device 1250 can store instructions for the electronic devices 644, the devices 704, the server device 726, the server device 812, the server device 818, the management device 902, a training device, an inferencing device, or the like.

Processor 1204 couples to the chipset 1232 via P2P interface 1228 and P2P 1234 while processor 1206 couples to the chipset 1232 via P2P interface 1230 and P2P 1236. Direct media interface (DMI) 1276 and DMI 1278 couple the P2P interface 1228 and the P2P 1234 and the P2P interface 1230 and P2P 1236, respectively. DMI 1276 and DMI 1278 is a high-speed interconnect that facilitates, e.g., eight Giga Transfers per second (GT/s) such as DMI 3.0. In other embodiments, the processor 1204 and processor 1206 interconnect via a bus.

The chipset 1232 comprises a controller hub such as a platform controller hub (PCH). The chipset 1232 includes a system clock to perform clocking functions and include interfaces for an I/O bus such as a universal serial bus (USB), peripheral component interconnects (PCIs), CXL interconnects, UCIe interconnects, interface serial peripheral interconnects (SPIs), integrated interconnects (I2Cs), and the like, to facilitate connection of peripheral devices on the platform. In other embodiments, the chipset 1232 comprises more than one controller hub such as a chipset with a memory controller hub, a graphics controller hub, and an input/output (I/O) controller hub.

In the depicted example, chipset 1232 couples with a trusted platform module (TPM) 1244 and UEFI, BIOS, FLASH circuitry 1246 via I/F 1242. The TPM 1244 is a dedicated microcontroller designed to secure hardware by integrating cryptographic keys into devices. The UEFI, BIOS, FLASH circuitry 1246 may provide pre-boot code. The I/F 1242 may also be coupled to a network interface circuit (NIC) 1280 for connections off-chip.

Furthermore, chipset 1232 includes the I/F 1238 to couple chipset 1232 with a high-performance graphics engine, such as, graphics processing circuitry or a graphics processing unit (GPU) 1248. In other embodiments, the computing architecture 1200 includes a flexible display interface (FDI) (not shown) between the processor 1204 and/or the processor 1206 and the chipset 1232. The FDI interconnects a graphics processor core in one or more of processor 1204 and/or processor 1206 with the chipset 1232.

The computing architecture 1200 is operable to communicate with wired and wireless devices or entities via the network interface (NIC) 180 using the IEEE 802 family of standards, such as wireless devices operatively disposed in wireless communication (e.g., IEEE 802.11 over-the-air modulation techniques). This includes at least Wi-Fi (or Wireless Fidelity), WiMax, and Bluetooth^{™} wireless technologies, 3G, 4G, LTE wireless technologies, among others. Thus, the communication is a predefined structure as with a conventional network or simply an ad hoc communication between at least two devices. Wi-Fi networks use radio technologies called IEEE 802.11x (a, b, g, n, ac, ax, etc.) to provide secure, reliable, fast wireless connectivity. A Wi-Fi network is used to connect computers to each other, to the Internet, and to wired networks (which use IEEE 802.3-related media and functions).

Additionally, accelerator 1254 and/or vision processing unit 1256 are coupled to chipset 1232 via I/F 1238. The accelerator 1254 is representative of any type of accelerator device (e.g., a data streaming accelerator, cryptographic accelerator, cryptographic coprocessor, an offload engine, etc.). One example of an accelerator 1254 is the Intel^{®} Data Streaming Accelerator (DSA). The accelerator 1254 is a device including circuitry to accelerate copy operations, data encryption, hash value computation, data comparison operations (including comparison of data in memory 1216 and/or memory 1218), and/or data compression. Examples for the accelerator 1254 include a USB device, PCI device, PCIe device, CXL device, UCIe device, and/or an SPI device. The accelerator 1254 also includes circuitry arranged to execute machine learning (ML) related operations (e.g., training, inference, etc.) for ML models. Generally, the accelerator 1254 is specially designed to perform computationally intensive operations, such as hash value computations, comparison operations, cryptographic operations, and/or compression operations, in a manner that is more efficient than when performed by the processor 1204 or processor 1206. Because the load of the computing architecture 1200 includes hash value computations, comparison operations, cryptographic operations, and/or compression operations, the accelerator 1254 greatly increases performance of the computing architecture 1200 for these operations.

The accelerator 1254 includes one or more dedicated work queues and one or more shared work queues (each not pictured). Generally, a shared work queue is configured to store descriptors submitted by multiple software entities. The software is any type of executable code, such as a process, a thread, an application, a virtual machine, a container, a microservice, etc., that share the accelerator 1254. For example, the accelerator 1254 is shared according to the Single Root I/O virtualization (SR-IOV) architecture and/or the Scalable I/O virtualization (S-IOV) architecture. Embodiments are not limited in these contexts. In some embodiments, software uses an instruction to atomically submit the descriptor to the accelerator 1254 via a non-posted write (e.g., a deferred memory write (DMWr)). One example of an instruction that atomically submits a work descriptor to the shared work queue of the accelerator 1254 is the ENQCMD command or instruction (which may be referred to as "ENQCMD" herein) supported by the Intel^{®} Instruction Set Architecture (ISA). However, any instruction having a descriptor that includes indications of the operation to be performed, a source virtual address for the descriptor, a destination virtual address for a device-specific register of the shared work queue, virtual addresses of parameters, a virtual address of a completion record, and an identifier of an address space of the submitting process is representative of an instruction that atomically submits a work descriptor to the shared work queue of the accelerator 1254. The dedicated work queue may accept job submissions via commands such as the movdir64b instruction.

Various I/O devices 1260 and display 1252 couple to the bus 1272, along with a bus bridge 1258 which couples the bus 1272 to a second bus 1274 and an I/F 1240 that connects the bus 1272 with the chipset 1232. In one embodiment, the second bus 1274 is a low pin count (LPC) bus. Various input/output (I/O) devices couple to the second bus 1274 including, for example, a keyboard 1262, a mouse 1264 and communication devices 1266.

Furthermore, an audio I/O 1268 couples to second bus 1274. Many of the I/O devices 1260 and communication devices 1266 reside on the system-on-chip (SoC) 1202 while the keyboard 1262 and the mouse 1264 are add-on peripherals. In other embodiments, some or all the I/O devices 1260 and communication devices 1266 are add-on peripherals and do not reside on the system-on-chip (SoC) 1202.

FIG. 13 illustrates a block diagram of an exemplary communications architecture 1300 suitable for implementing various embodiments as previously described. The communications architecture 1300 includes various common communications elements, such as a transmitter, receiver, transceiver, radio, network interface, baseband processor, antenna, amplifiers, filters, power supplies, and so forth. The embodiments, however, are not limited to implementation by the communications architecture 1300.

As shown in FIG. 13, the communications architecture 1300 includes one or more clients 1302 and servers 1304. The clients 1302 and the servers 1304 are operatively connected to one or more respective client data stores 1308 and server data stores 1310 that can be employed to store information local to the respective clients 1302 and servers 1304, such as cookies and/or associated contextual information.

The clients 1302 and the servers 1304 communicate information between each other using a communication framework 1306. The communication framework 1306 implements any well-known communications techniques and protocols. The communication framework 1306 is implemented as a packet-switched network (e.g., public networks such as the Internet, private networks such as an enterprise intranet, and so forth), a circuit-switched network (e.g., the public switched telephone network), or a combination of a packet-switched network and a circuit-switched network (with suitable gateways and translators).

The communication framework 1306 implements various network interfaces arranged to accept, communicate, and connect to a communications network. A network interface is regarded as a specialized form of an input output interface. Network interfaces employ connection protocols including without limitation direct connect, Ethernet (e.g., thick, thin, twisted pair 10/900/1000 Base T, and the like), token ring, wireless network interfaces, cellular network interfaces, IEEE 802.11 network interfaces, IEEE 802.16 network interfaces, IEEE 802.20 network interfaces, and the like. Further, multiple network interfaces are used to engage with various communications network types. For example, multiple network interfaces are employed to allow for the communication over broadcast, multicast, and unicast networks. Should processing requirements dictate a greater amount speed and capacity, distributed network controller architectures are similarly employed to pool, load balance, and otherwise increase the communicative bandwidth required by clients 1302 and the servers 1304. A communications network is any one and the combination of wired and/or wireless networks including without limitation a direct interconnection, a secured custom connection, a private network (e.g., an enterprise intranet), a public network (e.g., the Internet), a Personal Area Network (PAN), a Local Area Network (LAN), a Metropolitan Area Network (MAN), an Operating Missions as Nodes on the Internet (OMNI), a Wide Area Network (WAN), a wireless network, a cellular network, and other communications networks.

The various elements of the devices as previously described with reference to the figures include various hardware elements, software elements, or a combination of both. Examples of hardware elements include devices, logic devices, components, processors, microprocessors, circuits, processors, circuit elements (e.g., transistors, resistors, capacitors, inductors, and so forth), integrated circuits, application specific integrated circuits (ASIC), programmable logic devices (PLD), digital signal processors (DSP), field programmable gate array (FPGA), memory units, logic gates, registers, semiconductor device, chips, microchips, chip sets, and so forth. Examples of software elements include software components, programs, applications, computer programs, application programs, system programs, software development programs, machine programs, operating system software, middleware, firmware, software modules, routines, subroutines, functions, methods, procedures, software interfaces, application program interfaces (API), instruction sets, computing code, computer code, code segments, computer code segments, words, values, symbols, or any combination thereof. However, determining whether an embodiment is implemented using hardware elements and/or software elements varies in accordance with any number of factors, such as desired computational rate, power levels, heat tolerances, processing cycle budget, input data rates, output data rates, memory resources, data bus speeds and other design or performance constraints, as desired for a given implementation.

One or more examples of at least one embodiment are implemented by representative instructions stored on a machine-readable medium which represents various logic within the processor, which when read by a machine causes the machine to fabricate logic to perform the techniques described herein. Such representations, known as "intellectual property (IP) cores" are stored on a tangible, machine readable medium and supplied to various customers or manufacturing facilities to load into the fabrication machines that make the logic or processor. Some embodiments are implemented, for example, using a machine-readable medium or article which may store an instruction or a set of instructions that, when executed by a machine, causes the machine to perform a method and/or operations in accordance with the embodiments. Such a machine includes, for example, any suitable processing platform, computing platform, computing device, processing device, computing system, processing system, processing devices, computer, processor, or the like, and is implemented using any suitable combination of hardware and/or software. The machine-readable medium or article includes, for example, any suitable type of memory unit, memory device, memory article, memory medium, storage device, storage article, storage medium and/or storage unit, for example, memory, removable or non-removable media, erasable or non-erasable media, writeable or rewriteable media, digital or analog media, hard disk, floppy disk, Compact Disk Read Only Memory (CD-ROM), Compact Disk Recordable (CD-R), Compact Disk Rewriteable (CD-RW), optical disk, magnetic media, magneto-optical media, removable memory cards or disks, various types of Digital Versatile Disk (DVD), a tape, a cassette, or the like. The instructions include any suitable type of code, such as source code, compiled code, interpreted code, executable code, static code, dynamic code, encrypted code, and the like, implemented using any suitable high-level, low-level, object-oriented, visual, compiled and/or interpreted programming language.

As utilized herein, terms "component," "system," "interface," and the like are intended to refer to a computer-related entity, hardware, software (e.g., in execution), and/or firmware. For example, a component is a processor (e.g., a microprocessor, a controller, or other processing device), a process running on a processor, a controller, an object, an executable, a program, a storage device, a computer, a tablet PC and/or a user equipment (e.g., mobile phone, etc.) with a processing device. By way of illustration, an application running on a server and the server is also a component. One or more components reside within a process, and a component is localized on one computer and/or distributed between two or more computers. A set of elements or a set of other components are described herein, in which the term "set" can be interpreted as "one or more."

Further, these components execute from various computer readable storage media having various data structures stored thereon such as with a module, for example. The components communicate via local and/or remote processes such as in accordance with a signal having one or more data packets (e.g., data from one component interacting with another component in a local system, distributed system, and/or across a network, such as, the Internet, a local area network, a wide area network, or similar network with other systems via the signal).

As another example, a component is an apparatus with specific functionality provided by mechanical parts operated by electric or electronic circuitry, in which the electric or electronic circuitry is operated by a software application or a firmware application executed by one or more processors. The one or more processors are internal or external to the apparatus and execute at least a part of the software or firmware application. As yet another example, a component is an apparatus that provides specific functionality through electronic components without mechanical parts; the electronic components include one or more processors therein to execute software and/or firmware that confer(s), at least in part, the functionality of the electronic components.

Use of the word exemplary is intended to present concepts in a concrete fashion. As used in this application, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims should generally be construed to mean "one or more" unless specified otherwise or clear from context to be directed to a singular form. Furthermore, to the extent that the terms "including", "includes", "having", "has", "with", or variants thereof are used in either the detailed description and the claims, such terms are intended to be inclusive in a manner similar to the term "comprising." Additionally, in situations wherein one or more numbered items are discussed (e.g., a "first X", a "second X", etc.), in general the one or more numbered items may be distinct or they may be the same, although in some situations the context may indicate that they are distinct or that they are the same.

As used herein, the term "circuitry" may refer to, be part of, or include a circuit, an integrated circuit (IC), a monolithic IC, a discrete circuit, a hybrid integrated circuit (HIC), an Application Specific Integrated Circuit (ASIC), an electronic circuit, a logic circuit, a microcircuit, a hybrid circuit, a microchip, a chip, a chiplet, a chipset, a multi-chip module (MCM), a semiconductor die, a system on a chip (SoC), a processor (shared, dedicated, or group), a processor circuit, a processing circuit, or associated memory (shared, dedicated, or group) operably coupled to the circuitry that execute one or more software or firmware programs, a combinational logic circuit, or other suitable hardware components that provide the described functionality. In some embodiments, the circuitry is implemented in, or functions associated with the circuitry are implemented by, one or more software or firmware modules. In some embodiments, circuitry includes logic, at least partially operable in hardware. It is noted that hardware, firmware and/or software elements may be collectively or individually referred to herein as "logic" or "circuit."

Some embodiments are described using the expression "one embodiment" or "an embodiment" along with their derivatives. These terms mean that a particular feature, structure, or characteristic described in connection with the embodiment is included in at least one embodiment. The appearances of the phrase "in one embodiment" in various places in the specification are not necessarily all referring to the same embodiment. Moreover, unless otherwise noted the features described above are recognized to be usable together in any combination. Thus, any features discussed separately can be employed in combination with each other unless it is noted that the features are incompatible with each other.

Some embodiments are presented in terms of program procedures executed on a computer or network of computers. A procedure is here, and generally, conceived to be a self-consistent sequence of operations leading to a desired result. These operations are those requiring physical manipulations of physical quantities. Usually, though not necessarily, these quantities take the form of electrical, magnetic or optical signals capable of being stored, transferred, combined, compared, and otherwise manipulated. It proves convenient at times, principally for reasons of common usage, to refer to these signals as bits, values, elements, symbols, characters, terms, numbers, or the like. It should be noted, however, that all of these and similar terms are to be associated with the appropriate physical quantities and are merely convenient labels applied to those quantities.

Further, the manipulations performed are often referred to in terms, such as adding or comparing, which are commonly associated with mental operations performed by a human operator. No such capability of a human operator is necessary, or desirable in most cases, in any of the operations described herein, which form part of one or more embodiments. Rather, the operations are machine operations. Useful machines for performing operations of various embodiments include general purpose digital computers or similar devices.

Some embodiments are described using the expression "coupled" and "connected" along with their derivatives. These terms are not necessarily intended as synonyms for each other. For example, some embodiments are described using the terms "connected" and/or "coupled" to indicate that two or more elements are in direct physical or electrical contact with each other. The term "coupled," however, also means that two or more elements are not in direct contact with each other, but yet still co-operate or interact with each other.

Various embodiments also relate to apparatus or systems for performing these operations. This apparatus is specially constructed for the required purpose or it comprises a general purpose computer as selectively activated or reconfigured by a computer program stored in the computer. The procedures presented herein are not inherently related to a particular computer or other apparatus. Various general purpose machines are used with programs written in accordance with the teachings herein, or it proves convenient to construct more specialized apparatus to perform the required method steps. The required structure for a variety of these machines are apparent from the description given.

It is emphasized that the Abstract of the Disclosure is provided to allow a reader to quickly ascertain the nature of the technical disclosure. It is submitted with the understanding that it will not be used to interpret or limit the scope or meaning of the claims. In addition, the following claims are hereby incorporated into the Detailed Description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects.

The following examples pertain to further embodiments, from which numerous permutations and configurations will be apparent.

In one example, an apparatus, includes circuitry. The apparatus also includes memory operably coupled to the circuitry, the memory to store instructions that when executed by the circuitry causes the circuitry to detect a temperature of a semiconductor die meets a first threshold value of a dynamic temperature range for the semiconductor die, generate a first control directive for a liquid cooling system to start delivery of a cooling fluid to a liquid cooling component of the semiconductor die to reduce the temperature of the semiconductor die, detect the temperature of the semiconductor die meets a second threshold value of the dynamic temperature range for the semiconductor die, the second threshold value lower than the first threshold value of the dynamic temperature range, and generate a second control directive to stop delivery of the cooling fluid to the liquid cooling component of the semiconductor die.

The apparatus may also include generate a third control directive to drain the cooling fluid from the liquid cooling component of the semiconductor die.

The apparatus may also include where the first threshold value represents a silicon junction temperature within a safety range of the dynamic temperature range and the second threshold value represents a silicon junction temperature within an operating range of the dynamic temperature range.

The apparatus may also include generating the first threshold value or the second threshold value using a machine learning model.

The apparatus may also include where the first control directive includes a set of instructions, the set of instructions includes a first instruction to open a first valve of a fluid reservoir, a second instruction to open a second valve of a heat exchanger, a third instruction to a first pump to deliver the cooling fluid from the fluid reservoir to the liquid cooling component of the semiconductor die to absorb heat from the semiconductor die to form heated cooling fluid, and a fourth instruction to a second pump to deliver the heated cooling fluid from the liquid cooling component of the semiconductor die to the heat exchanger to remove heat from the heated cooling fluid.

The apparatus may also include where the second control directive includes a set of instructions, the set of instructions includes a first instruction to close a first valve of a fluid reservoir, a second instruction to a first pump to deliver the cooling fluid to the liquid cooling component of the semiconductor die to absorb heat from the semiconductor die to form heated cooling fluid, a third instruction to a second pump to deliver the heated cooling fluid from the liquid cooling component of the semiconductor die to the heat exchanger to remove heat from the heated cooling fluid, and a fourth instruction to close a second valve of the heat exchanger.

The apparatus may also include where the liquid cooling component includes a heat sink or a cold plate thermally coupled to the semiconductor die.

In one example, a system, includes a liquid cooling system includes a fluid reservoir to store cooling fluid. The system also includes circuitry operably coupled to the liquid cooling system. The system also includes memory operably coupled to the circuitry, the memory to store instructions that when executed by the circuitry causes the circuitry to detect a temperature of a semiconductor die meets a first threshold value of a dynamic temperature range for the semiconductor die, generate a first control directive for the liquid cooling system to start delivery of the cooling fluid from the fluid reservoir to a liquid cooling component of the semiconductor die to reduce the temperature of the semiconductor die, detect the temperature of the semiconductor die meets a second threshold value of the dynamic temperature range for the semiconductor die, the second threshold value lower than the first threshold value of the dynamic temperature range, and generate a second control directive to stop delivery of the cooling fluid from the fluid reservoir to the liquid cooling component of the semiconductor die.

The apparatus may also include the liquid cooling system includes a sensor to generate the temperature for the semiconductor die.

The apparatus may also include the liquid cooling system further includes a heat exchanger includes a radiator and a cooling fan, a first valve to control delivery of the cooling fluid from the fluid reservoir, a second valve to control delivery of heated cooling fluid to the heat exchanger, a first pump to deliver the cooling fluid from the fluid reservoir to the liquid cooling component of the semiconductor die to absorb heat from the semiconductor die to form heated cooling fluid, and a second pump to deliver the heated cooling fluid from the liquid cooling component of the semiconductor die to the heat exchanger to remove heat from the heated cooling fluid.

The apparatus may also include the semiconductor die mounted on a package substrate, a thermal interface material layer thermally coupled to the semiconductor die, and the liquid cooling component thermally coupled to the thermal interface material layer. The apparatus may also include where the liquid cooling component includes a heat sink or a cold plate thermally coupled to the semiconductor die.

In one example, a method, includes detecting a temperature of a semiconductor die meets a first threshold value of a dynamic temperature range for the semiconductor die, generating a first control directive for a liquid cooling system to start delivery of a cooling fluid to a liquid cooling component of the semiconductor die to reduce the temperature of the semiconductor die, detecting the temperature of the semiconductor die meets a second threshold value of the dynamic temperature range for the semiconductor die, the second threshold value lower than the first threshold value of the dynamic temperature range, and generating a second control directive to stop delivery of the cooling fluid to the liquid cooling component of the semiconductor die.

The method may also include generating a third control directive to drain the cooling fluid from the liquid cooling component of the semiconductor die.

The method may also include where the first threshold value represents a temperature within a safety range of the dynamic temperature range and the second threshold value represents a temperature within an operating range of the dynamic temperature range.

The method may also include generating the first threshold value or the second threshold value using a machine learning model.

The method may also include where the first control directive includes a set of instructions, the set of instructions includes a first instruction to open a first valve of a fluid reservoir, a second instruction to open a second valve of a heat exchanger, a third instruction to a first pump to deliver the cooling fluid from the fluid reservoir to the liquid cooling component of the semiconductor die to absorb heat from the semiconductor die to form heated cooling fluid, and a fourth instruction to a second pump to deliver the heated cooling fluid from the liquid cooling component of the semiconductor die to the heat exchanger to remove heat from the heated cooling fluid.

The method may also include where the second control directive includes a set of instructions, the set of instructions includes a first instruction to close a first valve of a fluid reservoir, a second instruction to a first pump to deliver the cooling fluid to the liquid cooling component of the semiconductor die to absorb heat from the semiconductor die to form heated cooling fluid, a third instruction to a second pump to deliver the heated cooling fluid from the liquid cooling component of the semiconductor die to the heat exchanger to remove heat from the heated cooling fluid, and a fourth instruction to close a second valve of the heat exchanger.

The apparatus may also include where the first control directive includes a set of instructions, the set of instructions includes a first instruction to open the first valve of the fluid reservoir, a second instruction to open the second valve of the heat exchanger, a third instruction to the first pump to deliver the cooling fluid from the fluid reservoir to the liquid cooling component of the semiconductor die to absorb heat from the semiconductor die to form heated cooling fluid, and a fourth instruction to the second pump to deliver the heated cooling fluid from the liquid cooling component of the semiconductor die to the heat exchanger to remove heat from the heated cooling fluid.

The apparatus may also include where the second control directive includes a set of instructions, the set of instructions includes a first instruction to close the first valve of the fluid reservoir, a second instruction to the first pump to deliver the cooling fluid to the liquid cooling component of the semiconductor die to absorb heat from the semiconductor die to form heated cooling fluid, a third instruction to the second pump to deliver the heated cooling fluid from the liquid cooling component of the semiconductor die to the heat exchanger to remove heat from the heated cooling fluid, and a fourth instruction to close the second valve of the heat exchanger.

## Claims

1. An apparatus, comprising:
circuitry; and
memory operably coupled to the circuitry, the memory to store instructions that when executed by the circuitry causes the circuitry to:
detect a temperature of a semiconductor die meets a first threshold value of a dynamic temperature range for the semiconductor die;
generate a first control directive for a liquid cooling system to start delivery of a cooling fluid to a liquid cooling component of the semiconductor die to reduce the temperature of the semiconductor die;
detect the temperature of the semiconductor die meets a second threshold value of the dynamic temperature range for the semiconductor die, the second threshold value lower than the first threshold value of the dynamic temperature range; and
generate a second control directive to stop delivery of the cooling fluid to the liquid cooling component of the semiconductor die.

2. The apparatus of claim 1, comprising generate a third control directive to drain the cooling fluid from the liquid cooling component of the semiconductor die.

3. The apparatus of any of claims 1 to 2, wherein the first threshold value represents a silicon junction temperature within a safety range of the dynamic temperature range and the second threshold value represents a silicon junction temperature within an operating range of the dynamic temperature range.

4. The apparatus of any of claims 1 to 3, comprising generating the first threshold value or the second threshold value using a machine learning model.

5. The apparatus of any of claims 1 to 4, wherein the first control directive comprises a set of instructions, the set of instructions comprising:
a first instruction to open a first valve of a fluid reservoir;
a second instruction to open a second valve of a heat exchanger;
a third instruction to a first pump to deliver the cooling fluid from the fluid reservoir to the liquid cooling component of the semiconductor die to absorb heat from the semiconductor die to form heated cooling fluid; and
a fourth instruction to a second pump to deliver the heated cooling fluid from the liquid cooling component of the semiconductor die to the heat exchanger to remove heat from the heated cooling fluid.

6. The apparatus of any of claims 1 to 5, wherein the second control directive comprises a set of instructions, the set of instructions comprising:
a first instruction to close a first valve of a fluid reservoir;
a second instruction to a first pump to deliver the cooling fluid to the liquid cooling component of the semiconductor die to absorb heat from the semiconductor die to form heated cooling fluid;
a third instruction to a second pump to deliver the heated cooling fluid from the liquid cooling component of the semiconductor die to the heat exchanger to remove heat from the heated cooling fluid; and
a fourth instruction to close a second valve of the heat exchanger.

7. The apparatus of any of claims 1 to 6, wherein the liquid cooling component comprises a heat sink or a cold plate thermally coupled to the semiconductor die.

8. A method, comprising:
detecting a temperature of a semiconductor die meets a first threshold value of a dynamic temperature range for the semiconductor die;
generating a first control directive for a liquid cooling system to start delivery of a cooling fluid to a liquid cooling component of the semiconductor die to reduce the temperature of the semiconductor die;
detecting the temperature of the semiconductor die meets a second threshold value of the dynamic temperature range for the semiconductor die, the second threshold value lower than the first threshold value of the dynamic temperature range; and
generating a second control directive to stop delivery of the cooling fluid to the liquid cooling component of the semiconductor die.

9. The method of claim 8, comprising generating a third control directive to drain the cooling fluid from the liquid cooling component of the semiconductor die.

10. The method of any of claims 8 to 9, wherein the first threshold value represents a temperature within a safety range of the dynamic temperature range and the second threshold value represents a temperature within an operating range of the dynamic temperature range.

11. The method of any of claims 8 to 10, comprising generating the first threshold value or the second threshold value using a machine learning model.

12. The method of any of claims 8 to 11, wherein the first control directive comprises a set of instructions, the set of instructions comprising:
a first instruction to open a first valve of a fluid reservoir;
a second instruction to open a second valve of a heat exchanger;
a third instruction to a first pump to deliver the cooling fluid from the fluid reservoir to the liquid cooling component of the semiconductor die to absorb heat from the semiconductor die to form heated cooling fluid; and
a fourth instruction to a second pump to deliver the heated cooling fluid from the liquid cooling component of the semiconductor die to the heat exchanger to remove heat from the heated cooling fluid.

13. The method of any of claims 8 to 12, wherein the second control directive comprises a set of instructions, the set of instructions comprising:
a first instruction to close a first valve of a fluid reservoir;
a second instruction to a first pump to deliver the cooling fluid to the liquid cooling component of the semiconductor die to absorb heat from the semiconductor die to form heated cooling fluid;
a third instruction to a second pump to deliver the heated cooling fluid from the liquid cooling component of the semiconductor die to the heat exchanger to remove heat from the heated cooling fluid; and
a fourth instruction to close a second valve of the heat exchanger.

14. An apparatus comprising means to perform a method as claimed in any preceding claim.

15. Machine-readable storage including machine-readable instructions, when executed, to implement a method or realize an apparatus as claimed in any preceding claim.
